(19) Europäisches Patentamt
European Patent Office
Office européen des brevets

(11) EP 1 900 769 A1

(12) EUROPEAN PATENT APPLICATION
published in accordance with Art. 153(4) EPC

(43) Date of publication:
**19.03.2008 Bulletin 2008/12**

(21) Application number: **06767057.0**

(22) Date of filing: **21.06.2006**

(51) Int Cl.:
***C08K 9/04*** *(2006.01)* ***C08L 101/00*** *(2006.01)*

(86) International application number:
**PCT/JP2006/312398**

(87) International publication number:
**WO 2006/137430 (28.12.2006 Gazette 2006/52)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **21.06.2005 JP 2005181011**

(71) Applicant: **Nisshinbo Industries, Inc.**
**Chuo-ku,**
**Tokyo 103-8650 (JP)**

(72) Inventors:
- **TSUKAMOTO, Nami,**
**c/o NISSHINBO INDUSTRIES, INC.**
**Chiba-shi,**
**Chiba 267-0056 (JP)**
- **HASHIBA, Toshifumi,**
**c/o NISSHINBO INDUSTRIES, INC.**
**Chiba-shi,**
**Chiba 267-0056 (JP)**
- **MIZUSHIRI, Mayumi,**
**c/o NISSHINBO INDUSTRIES, INC.**
**Chiba-shi,**
**Chiba 267-0056 (JP)**

(74) Representative: **Stuart, Ian Alexander et al**
**Mewburn Ellis LLP**
**York House**
**23 Kingsway**
**London WC2B 6HP (GB)**

# (54) FLAME RETARDANT AND INORGANIC/ORGANIC COMPOSITE FLAME-RETARDANT COMPOSITION

(57) A flame retardant which comprises an inorganic hydroxide and a carbodiimide-group-containing organic layer chemically bonded to the surface of the inorganic hydroxide. Examples of the carbodiimide-group-containing organic layer include a layer comprising a carbodiimide-group-containing compound represented by either of the following formulae. Due to the constitution, the flame retardant can be highly dispersed in a resin even when added in a high proportion and can give a molding inhibited from deteriorating in electrical properties, mechanical properties, etc.

$$(X^1)_m\text{-}Z\text{-}[A\text{-}(R^1\text{-}N{=}C{=}N)_n\text{-}R^1\text{-}NCO]_1 \qquad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_1 \qquad (2)$$

[$R^1$ represents a residue of an isocyanate compound; $X^1$ and $X^2$ each independently represents hydrogen, halogeno, etc.; Z's each independently represents silicon or titanium; A represents an organic group having a valence of 2 or higher containing a bond derived from an isocyanate group; m and 1 each is an integer of 1-3, provided that m+1=4; and n is an integer of 1-100.]

EP 1 900 769 A1

## Description

### TECHNICAL FIELD

The present invention relates to a flame retardant and to inorganic/organic composite flame-retardant compositions.

### BACKGROUND ART

Flame-retarding materials have been widely used recently in such applications as electronic materials and construction materials. Flame-retarding materials are generally prepared by compounding a flame retardant with a resin. Known flame retardants include halogenated compounds, antimony trioxide, phosphorus compounds and inorganic hydroxides (e.g., hydrated metal compounds).
The use of halogenated compounds and antimony trioxide has been restricted in recent years due to concerns over their effects on the environment, such as depletion of the ozone layer and the role they play in dioxin generation. The use of phosphorus compounds is generally avoided because their high unit cost tends to increase production costs.
Inorganic hydroxides, on the other hand, are regarded as being particularly useful as flame retardants because they are relatively flameproof, in addition to which they are inexpensive and environmentally friendly.
However, when an inorganic hydroxide is used as a flame retardant, compared with organic flame retardants, a larger amount must be included in the composition to achieve the same level of flame-retarding effects as organic flame retardants. It is therefore very important to improve the affinity between polymeric materials and the inorganic hydroxide. Many surface modification methods are carried out on inorganic hydroxides for this purpose.
One of the most widely used surface modification methods is a process in which the surface of the inorganic hydroxide is coated with an organic compound. In this process, the ability of the organic compound to adhere to the surface of the inorganic hydroxide is important.
If the inorganic hydroxide has a functional group, a strong coat can be formed by using a compound having a substituent capable of reacting with the functional group (e.g., a hydroxyl group), such as a silane coupling agent (see Patent Document 2: JP-A 61-275359; Patent Document 3: JP-A 63-258958).
However, prior-art flame retardants composed of inorganic hydroxides which are surface-treated in the above manner have hitherto exhibited a variety of problems, such as the following.

(1) Problems with Electrical Properties:

Because inorganic hydroxides have a high dielectric constant, the addition of a large amount of inorganic hydroxide may increase the dielectric constant of shaped articles made from the ensuing composition.
Inorganic hydroxides lack an adequate dispersibility, making it necessary to add a dispersant such as colloidal silica to improve the dispersibility. However, such addition also increases the dielectric constant of the resulting shaped articles.
The addition of an inorganic hydroxide lowers the resistance to migration and the insulation reliability of shaped articles obtained therefrom.

(2) Problems with Mechanical Properties:

When a large amount of an inorganic hydroxide having insufficient affinity with the resin is added, the shaped article becomes brittle.
Because inorganic hydroxides lack a sufficient dispersibility, it is difficult to achieve high loadings of inorganic hydroxide in resin.

(3) Problems with Acid/Alkali Resistance:

Some types of inorganic hydroxides have inherently low acid and alkali resistances. Compositions in which such an inorganic hydroxide has been added as the flame retardant have inadequate acid and alkali resistances.
In electronic material-related applications, the acid resistance is an indispensable quality during etching treatment.

(4) Problems with Thermal Properties:

Inorganic hydroxides lack sufficient dispersibility. The addition of a dispersant or the use of an inorganic surface treatment agent to improve the dispersibility has the effect of lowering the thermal resistance.

(5) Problems with Flame-Retarding Effects:

Because inorganic hydroxides have an inadequate dispersibility in resin, high loadings of such compounds are difficult in achieve in resins. This in turn makes it impossible to confer a sufficient flame retardance.
The flame-retarding effects are proportional to the specific surface area of the inorganic hydroxide. Hence, if the inorganic hydroxide is present within the resin in an agglomerated, inadequately dispersed state, the flame-retarding effects are diminished.
Inorganic hydroxides have an insufficient dispersibility. The addition of a dispersant or the use of an inorganic surface treatment agent to improve the dispersibility has the effect of lowering the flame retardance.

Given such deterioration in the mechanical properties, electrical properties and chemical properties of shaped articles, there are limitations on the amount of inorganic hydroxide that may be loaded into a resin, thus making it difficult to fully manifest the required flame retardance.
Patent Document 1: JP-A 5-230279
Patent Document 2: JP-A 61-275359
Patent Document 3: JP-A 63-258958

DISCLOSURE OF THE INVENTION

Problems to be Solved by the Invention

It is therefore an object of the present invention to provide a flame retardant which, even at high loadings in resin, disperses well and is thus able to suppress losses in the electrical, mechanical and other properties of the shaped articles obtained therefrom. Another object of the invention is to provide inorganic/organic composite flame-retardant compositions which include such a flame retardant and an organic resin.

Means for Solving the Problems

The inventors have conducted extensive investigations in order to achieve the above objects. As a result, they have discovered that flame retardants which form a carbodiimide group-containing organic layer on an inorganic hydroxide surface disperse well in resins, even at high loadings, and are able to suppress losses in the electrical characteristics (increased dielectric constant, decreased migration resistance), losses in the mechanical characteristics (embrittlement) and losses in the thermal characteristics of shaped articles obtained therefrom, while nonetheless conferring sufficient flame retardance to the shaped articles.
Accordingly, the present invention provides the following flame retardants and inorganic/organic composite flame-retardant compositions.

[1] A flame retardant which is characterized by comprising an inorganic hydroxide and a carbodiimide group-containing organic layer that is chemically bonded to a surface of the inorganic hydroxide.
[2] The flame retardant of [1] wherein, when tetrahydrofuran is used as a dispersing medium, the inorganic hydroxide having said carbodiimide group-containing organic layer has a particle size distribution with a standard deviation ($A_2$) which satisfies the following relationship with respect to a standard deviation ($A_1$) of the particle size distribution for a surface-untreated inorganic hydroxide:

$$(A_2)/(A_1) \leq 1.0.$$

[3] The flame retardant of [1] wherein, when tetrahydrofuran is used as a dispersing medium, the inorganic hydroxide having said carbodiimide group-containing organic layer has a volume mean particle diameter ($M_2$) which satisfies the following relationship with respect to a volume mean particle diameter ($M_1$) of a surface-untreated inorganic hydroxide:

$$(M_2)/(M_1) \leq 1.0.$$

[4] The flame retardant of [1] wherein, when pH 7 water is used as a dispersing medium, the inorganic hydroxide having said carbodiimide group-containing organic layer has a particle size distribution with a standard deviation ($A_4$) which satisfies the following relationship with respect to a standard deviation ($A_3$) of the particle size distribution for a surface-untreated inorganic hydroxide:

$$(A_4)/(A_3) > 1.0.$$

[5] The flame retardant of [1] wherein, when pH 7 water is used as a dispersing medium, the inorganic hydroxide having said carbodiimide group-containing organic layer has a volume mean particle diameter ($M_4$) which satisfies the following relationship with respect to a volume mean particle diameter ($M_3$) of a surface-untreated inorganic hydroxide:

$$(M_4)/(M_3) > 1.0.$$

[6] The flame retardant of [1], wherein said carbodiimide group-containing organic layer is at least one compound selected from among carbodiimide group-containing compounds of formula (1) below and carbodiimide group-containing compounds of formula (2) below:

$$(X^1)_m\text{-}Z\text{-}[A\text{-}(R^1\text{-}N{=}C{=}N)_n\text{-}R^1\text{-}NCO]_1 \qquad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_1 \qquad (2)$$

wherein

$R^1$ is a residue from an isocyanate compound;
$X^1$ and $X^2$ are each independently a hydrogen atom, a halogen atom, an alkyl group of 1 to 20 carbons which may include an unsaturated structure, an aryl group of 6 to 20 carbons, an aralkyl group of 7 to 20 carbons or an alkoxy group of 1 to 20 carbons, and $X^1$ and $X^2$ in each instance, if plural, may be the same or different;
each Z is independently a silicon atom or a titanium atom;
A is an organic group which has a valence of 2 or more and includes a bond derived from an isocyanate group;
the letters m and 1 are integers from 1 to 3 which satisfy the condition m+1 = 4; and
the letter n is an integer from 1 to 100.

[7] The flame retardant of [6], wherein at least one terminal isocyanate group on the carbodiimide group-containing compound of formula (1) is capped with a functional group which is reactive with isocyanate groups.
[8] The flame retardant of [7], wherein said functional group which is reactive with isocyanate groups is a hydroxyl group, a primary or secondary amino group, a carboxyl group or a thiol group.
[9] The flame retardant of any of [1] to [8], wherein the carbodiimide group-containing organic layer is lipophilic.
[10] The flame retardant of any one of [1] to [9], wherein the inorganic hydroxide is composed of particles having a volume mean particle diameter of from 1 nm to 100 μm.
[11] An inorganic/organic composite flame-retardant composition which is characterized by comprising the flame retardant of any one of [1] to [10] and an organic resin.
[12] The inorganic/organic composite flame-retardant composition of [11], wherein the flame retardant is included in an amount of at least 15 wt%, based on the organic resin.
[13] The inorganic/organic composite flame-retardant composition of [11] or [12], wherein the flame retardant included in 1 g of the composition has a total surface area of at least 2,000 $cm^2$.

## BENEFITS OF THE INVENTION

Because the surface of the inorganic hydroxide therein is covered with a carbodiimide group-containing organic

layer, the flame retardant of the invention has a good affinity with and dispersibility in organic resins and organic solvents. Moreover, the organic resin and carbodiimide groups trigger chemical reactions, enabling the formation of strong bonds. Therefore, even when a large amount of this flame retardant is included in an organic resin, decreases in the mechanical strength and in the electrical properties (e.g., migration resistance) of shaped articles obtained from the resulting composition can be suppressed.
Furthermore, because the flame retardant of the invention has an excellent dispersibility in organic resins and organic solvents, there is no need for the concomitant use of a dispersant, making it possible to prevent the rise in dielectric constant and the declines in heat resistance and flame retardance associated with the use of dispersants that have been observed in prior-art products.
Hence, by using the flame retardant of the invention, declines in the physical, electrical, thermal and chemical properties of the resulting shaped articles can be suppressed even when the amount of such addition is increased. Consequently, such shaped articles can be effectively imparted with various advantageous effects of inorganic hydroxide addition, such as flame retardance and a lower thermal expansion coefficient.

## BEST MODE FOR CARRYING OUT THE INVENTION

The invention is described more fully below.
The flame retardant of the invention is composed of an inorganic hydroxide and a carbodiimide group-containing organic layer that is chemically bonded to a surface of the inorganic hydroxide.
The inorganic hydroxide in the invention, although not subject to any particular limitation, is exemplified by aluminum hydroxide, magnesium hydroxide, potassium hydroxide, calcium hydroxide, nickel hydroxide, chromium hydroxide, iron hydroxide and copper hydroxide. The use of aluminum hydroxide, magnesium hydroxide, potassium hydroxide and calcium hydroxide is preferred because these hydroxides are widely used as flame retardants and are readily available. The use of magnesium hydroxide and/or aluminum hydroxide, which are widely used as flame retardants, is especially preferred.
The shape of the inorganic hydroxide will vary according to the intended use of the composition and therefore cannot be strictly specified. However, in light of such considerations as the dispersibility of the inorganic hydroxide in the composition, the moldability of the composition and the flame retardance improving effect which is proportional to the specific surface area (see *Kobunshi* no *nannen-ka gijutsu* [Polymer flame-retarding technology], published by CMC Shuppan), it is desirable for the inorganic hydroxide to be in the form of particles having a volume mean particle diameter of from 1 nm to 100 μm, preferably from 10 nm to 50 μm, and more preferably from 20 nm to 30 μm.
The carbodiimide group-containing organic layer in the invention is composed of a carbodiimide group-containing compound.
No limitation is imposed on the carbodiimide group-containing compound, provided the compound contains a carbodiimide group. For example, use may be made of a compound of formula (I) below.

$$OCN\text{-}(R^1\text{-}N{=}C{=}N)_n\text{-}R^1\text{-}NCO \qquad (I)$$

In formula (I), $R^1$ is a residue from an isocyanate compound, and the letter n is an integer from 1 to 100.
Carbodiimide group-containing compounds of above formula (I) (referred to below as simply "carbodiimide compounds") can be obtained in the presence of a catalyst which promotes the conversion of isocyanate groups on an organic polyisocyanate compound to carbodiimide groups. Illustrative examples include carbodiimide compounds which can be prepared by the method disclosed in JP-A 51-61599, the method of L. M. Alberino et al. (J. Appl. Polym. Sci., 21, 190 (1990)), or the method disclosed in JP-A 2-292316.
The carbodiimide compound of formula (I) has a weight-average molecular weight of generally about 200 to about 100,000. From the standpoint of dispersibility in organic resins and organic solvents, a weight-average molecular weight of from 500 to 50,000 is preferred.
Illustrative examples of organic isocyanate compounds which may be used to prepare the carbodiimide compound include 4,4'-dicyclohexylmethane diisocyanate, m-tetramethylxylylene diisocyanate, 2,4-tolylene diisocyanate, 2,6-tolylene diisocyanate, mixtures of 2,4-tolylene diisocyanate and 2,6-tolylene diisocyanate, crude tolylene diisocyanate, crude methylenediphenyl diisocyanate, 4,4',4"-triphenylmethylene triisocyanate, xylene diisocyanate, hexamethylene-1,6-diisocyanate, lysine diisocyanate, hydrogenated methylenediphenyl diisocyanate, m-phenyl diisocyanate, naphthylene-1,5-diisocyanate, 4,4'-biphenylene diisocyanate, 4,4'-diphenylmethane diisocyanate, 3,3'-dimethoxy-4,4'-biphenyl diisocyanate, 3,3'-dimethyldiphenylmethane-4,4'-diisocyanate and isophorone diisocyanate. These may be used singly or as mixtures of two or more thereof. Of these, for reasons having to do with the reactivity and the dispersibility in resins, 4,4'-diphenylmethane diisocyanate, 2,4-tolylene diisocyanate, hexamethylene-1,6-diisocyanate, m-tetramethylxylylene diisocyanate and 4,4'-dicyclohexylmethane diisocyanate are preferred.
Polycondensation arises via the conversion of isocyanate groups in the foregoing organic isocyanate compounds to carbodiimide. This reaction is typically carried out by heating the organic isocyanate compound in the presence of a carbodiimidation catalyst. At this time, the molecular weight (degree of polymerization) of the carbodiimide compound obtained can be adjusted by adding at an appropriate stage, as an end-capping agent, a compound having a functional group capable of reacting with the isocyanate group, such as a hydroxyl group, a primary or secondary amino group, a carboxyl group or a thiol group, and thereby capping the ends of the carbodiimide compound. The degree of polymerization can also be adjusted by means of such parameters as the concentration of the isocyanate compound and the reaction time. Any of various carbodiimidation catalysts may be used, although the use of, for example, 1-phenyl-2-phospholene-1-oxide, 3-methyl-1-phenyl-2-phospholene-1-oxide, 1-ethyl-2-phospholene-1-oxide and 3-phospholene isomers thereof is preferred from the standpoint of product yield and other considerations.

The above reaction may be carried out either in the presence or absence of a catalyst. It is also possible to add a solvent at the time of the reaction.

The solvent, so long as it does not exert an influence on the isocyanate groups and the carbodiimide groups at the time of the reaction, is not subject to any particular limitation. The solvent may be suitably selected in accordance with the method of polymerization.

Specific examples of solvents that may be used include ketones such as acetone, methyl ethyl ketone, methyl isobutyl ketone and cyclohexanone; esters such as ethyl acetate, butyl acetate, ethyl propionate and cellosolve acetate; aliphatic or aromatic hydrocarbons such as pentane, 2-methylbutane, n-hexane, cyclohexane, 2-methylpentane, 2,2-dimethylbutane, 2,3-dimethylbutane, heptane, n-octane, isooctane, 2,2,3-trimethylpentane, decane, nonane, cyclopentane, methylcyclopentane, methylcyclohexane, ethylcyclohexane, p-menthane, benzene, toluene, xylene and ethylbenzene; halogenated hydrocarbons such as carbon tetrachloride, trichloroethylene, chlorobenzene and tetrabromoethane; ethers such as ethyl ether, dimethyl ether, trioxane and tetrahydrofuran; acetals such as methylal and diethylacetal; and sulfur or nitrogen-containing organic compounds such as nitropropene, nitrobenzene, pyridine, dimethylformamide and dimethylsulfoxide. These may be used singly or as combinations of two or more thereof.

Moreover, in cases where the ends of the carbodiimide compound are capped with, for example, the subsequently described end-capping segments and thereby rendered hydrophilic, diluents that may be used include, in addition to the above-mentioned solvents: water; alcohols such as methanol, ethanol, 1-propanol, 2-propanol, 1-butanol, 2-butanol, isobutyl alcohol, tert-butyl alcohol, 1-pentanol, 2-pentanol, 3-pentanol, 2-methyl-1-butanol, isopentyl alcohol, tert-pentyl alcohol, 1-hexanol, 2-methyl-1-pentanol, 4-methyl-2-pentanol, 2-ethylbutanol, 1-heptanol, 2-heptanol, 3-heptanol, 2-octanol, 2-ethyl-1-hexanol, benzyl alcohol and cyclohexanol; ether alcohols such as methyl cellosolve, ethyl cellosolve, isopropyl cellosolve, butyl cellosolve and diethylene glycol monobutyl ether. These may be used singly or as combinations of two or more thereof. Because carbodiimide groups have a high reactivity, it is preferable to carry out dilution at a relatively low temperature.

In the flame retardant of the invention, a compound of formula (1) or (2) below may be used as the carbodiimide group-containing compound. With the use of these compounds, a carbodiimide group-containing organic layer can be efficiently formed on the surface of the inorganic hydroxide, which is especially preferred.

$$(X^1)_m\text{-Z-[A-(R}^1\text{-N=C=N)}_n\text{-R}^1\text{-NCO]}_1 \qquad (1)$$

$$(X^1)_m\text{-Z-[A-(R}^1\text{-N=C=N)}_n\text{-R}^1\text{-A-Z-(X}^2)_3]_1 \qquad (2)$$

In above formulas (1) and (2), $R^1$ is a residue from an isocyanate compound. "A residue from an isocyanate compound" refers herein to the partial structure which results from the removal of the isocyanate groups from an organic isocyanate compound and which remains in the carbodiimide compound when a (poly)carbodiimide compound is prepared from the isocyanate compound.

$X^1$ and $X^2$ are each independently a hydrogen atom, a halogen atom, an alkyl group of 1 to 20 carbons which may include an unsaturated structure, an aryl group of 6 to 20 carbons, an aralkyl group of 7 to 20 carbons, or an alkoxy group of 1 to 20 carbons. If there are a plurality of $X^1$ moieties, each instance of $X^1$ may be the same or different. Likewise, if there are a plurality of $X^2$ moieties, each instance of $X^2$ may be the same or different.

The halogen atom may be a fluorine, chlorine, bromine or iodine atom.

The alkyl group of 1 to 20 carbons which may include an unsaturated structure may have a linear, branched or cyclic structure. Illustrative examples include methyl, ethyl, n-propyl, n-butyl, isopropyl, isobutyl, sec-butyl, tert-butyl, cyclopropyl, cyclobutyl, cyclopentyl, methylcyclopentyl and cyclohexyl groups.

Examples of aryl groups of 6 to 20 carbons include phenyl, tolyl and biphenyl groups.

The aralkyl group of 7 to 20 carbons is exemplified by a benzyl group.

Examples of alkoxy groups of 1 to 20 carbons include methoxy, ethoxy, n-butoxy, t-butoxy and phenoxy groups. The alkyl moiety in the alkoxy group may have a linear, branched or cyclic structure.

The letter A represents an organic group with a valence of 2 or more that includes a bond derived from an isocyanate group.

"A bond derived from an isocyanate group" refers herein to a bond which forms from the reaction of an isocyanate group with a functional group capable of reacting with the isocyanate group.

Illustrative, non-limiting, examples of functional groups capable of reacting with the isocyanate group include hydroxyl groups, primary or secondary amino groups, carboxyl groups and thiol groups.

The bond which forms from the reaction of these functional groups with an isocyanate group is exemplified by urethane bonds, thiourethane bonds, urea bonds, amide bonds, carbodiimide bonds, allophanate bonds, biuret bonds, acylurea bonds, urethane-imine bonds, isocyanate dimerization bonds and isocyanate trimerization bonds. Of these, at least one type selected from among urea bonds, urethane bonds, thiourethane bonds and amide bonds is preferred because the reaction can easily be carried out at a relatively low temperature to form the bond.

The letter A may additionally include linkages between the isocyanate group-derived bond and Z. Illustrative, non-limiting, examples of such linkages include $-(CH_2)_k-$, $-(CH_2)_k-NH-(CH_2)_k-$, $-CO-NH-(CH_2)_k-$ (the letter k above representing an integer from 1 to 20), -CO-O- and -O-.

The letter m in $(X^1)_m$ above is an integer from 1 to 3, although it is preferable for m to be 3 (particularly in the case of formula (1) compounds).

If there are a plurality of $X^1$ moieties, taking into account the reactivity of the compounds of formulas (1) and (2) with the inorganic hydroxide surface, it is preferable for at least one $X^1$ moiety to be an alkoxy group of 1 to 20 carbons, and preferably 1 to 5 carbons, and most preferable for all the $X^1$ moieties to be alkoxy groups of 1 to 5 carbons.

With regard to the $X^2$ moieties, for the same reason, it is preferable for at least one $X^2$ moiety to be an alkoxy group of 1 to 20 carbons, and preferably 1 to 5 carbons, and most preferable for all the $X^2$ moieties to be alkoxy groups of 1 to 5 carbons.

Preferred examples of alkoxy groups having 1 to 5 carbons include methoxy and ethoxy groups.

The letters m and 1 are integers from 1 to 3 which satisfy the condition m+1 = 4, although it is preferable, in keeping with the preferred value of m noted above, for the letter 1 to be 1 (particularly in the case of formula (1) compounds).

Each Z is independently a silicon atom or a titanium atom. Here, in above formula (1), $(X)_m$-Z- is preferably a site capable of functioning as a coupling agent. In above formula (2), at least one of $(X^1)_m$-Z- and -Z-$(X^2)_3$ is preferably a site capable of functioning as a coupling agent.

Taking these points into account, it is preferable for the Z moiety in formula (1) and for the two Z moieties in formula (2) to be silicon atoms. The above formulas (1) and (2) in such a case are represented by formulas (1') and (2') below.

$$(X^1)_m\text{-Si-}[A\text{-}(R^1\text{-N=C=N})_n\text{-}R^1\text{-NCO}]_1 \qquad (1')$$

$$(X^1)_m\text{-Si-}[A\text{-}(R^1\text{-N=C=N})_n\text{-}R^1\text{-A-Si-}(X^2)_3]_1 \qquad (2')$$

In the above formulas, $X^1$, $X^2$, A, $R^1$, l, m and n are as described above.

The compound represented by above formula (1) or (2) has a weight-average molecular weight of preferably from 300 to 100,000, more preferably from 500 to 50,000, even more preferably from 600 to 40,000, and most preferably from 1,000 to 20,000. At a weight-average molecular weight of more than 100,000, steric hindrance becomes substantial, possibly resulting in a loss of the surface treatment effect (i.e., efficient surface modification of the inorganic hydroxide) by the compound.

The letter n above is an integer from 1 to 100. However, taking into account the fact that, as noted above, a rise in the weight-average molecular weight leads to an increase in steric hindrance, which may lower the surface treatment effect, it is preferable for the letter n to be from 2 to 80.

The carbodiimide group-containing compound of above formula (1) or (2) may be obtained by, for example, at any stage in the preparation of the compound of above formula (I), reacting a silicon or titanium atom-containing coupling agent having a functional group or bonding group capable of reacting with an isocyanate group on the carbodiimide compound.

In this coupling agent, the functional group or bonding group which is reactive with an isocyanate group is not subject to any particular limitation provided it is a group capable of reacting with an isocyanate group. Illustrative examples include hydroxyl groups, amino groups (preferably primary or secondary), carboxyl groups, thiol groups, isocyanate groups, epoxy groups, urethane bonds, urea bonds, amide bonds and acid anhydride groups. Of these, widely available amino groups (preferably primary or secondary), thiol groups, isocyanate groups and epoxy groups are preferred.

Specific examples of silane coupling agents include the following.

Examples of amino group-containing silane coupling agents include γ-aminopropyltrimethoxysilane, γ-aminopropyltriethoxysilane, γ-aminopropylmethyldimethoxysilane, γ-aminopropyldimethylmethoxysilane, γ-aminopropylmethyldiethoxysilane, γ-aminopropyldimethylethoxysilane, N-phenyl-γ-aminopropyltrimethoxysilane, N-phenyl-γ-aminopropyltriethoxysilane, N-β-(aminoethyl)-γ-aminopropyltrimethoxysilane, N-β-(aminoethyl)-γ-aminopropyltriethoxysilane, N-β-(aminoethyl)-γ-aminopropylmethyldimethoxysilane and N-β-(aminoethyl)-γ-aminopropylmethyldimethyldiethoxysilane.

Examples of thiol group-containing silane coupling agents include 3-mercaptopropyltrimethoxysilane, 3-mercaptopropyltriethoxysilane, mercaptomethyldimethylethoxysilane, (mercaptomethyl)methyldiethoxysilane and 3-mercaptopropylmethyldimethoxysilane.
Examples of isocyanate group-containing silane coupling agents include γ-isocyanatopropyltrimethoxysilane, γ-isocyanatopropyltriethoxysilane, γ-isocyanatopropylmethyldimethoxysilane, γ-isocyanatopropyldimethylmethoxysilane, γ-isocyanatopropylmethyldiethoxysilane and γ-isocyanatopropyldimethylethoxysilane.

Examples of epoxy group-containing silane coupling agents include γ-glycidoxypropyltrimethoxysilane, γ-glycidoxypropyltriethoxysilane, γ-glycidoxypropylmethyldimethoxysilane, γ-glycidoxypropyldimethylmethoxysilane, γ-glycidoxypropylmethyldiethoxysilane, γ-glycidoxypropyldimethylethoxysilane, γ-glycidoxypropylethyldimethoxysilane, γ-glycidoxypropyldiethylmethoxysilane, γ-glycidoxypropylethyldiethoxysilane, γ-glycidoxypropyldiethylethoxysilane, β-(3,4-epoxycyclohexyl)ethyltrimethoxysilane, β-(3,4-epoxycyclohexyl)ethyltriethoxysilane, β-(3,4-epoxycyclohexyl)ethylmethyldimethoxysilane, β-(3,4-epoxycyclohexyl)ethyldimethylmethoxysilane, β-(3,4-epoxycyclohexyl)ethylmethyldiethoxysilane, β-(3,4-epoxycyclohexyl)ethyldimethylethoxysilane, β-(3,4-epoxycyclohexyl)ethylethyldimethoxysilane, β-(3,4-epoxycyclohexyl)ethyldiethylmethoxysilane, β-(3,4-epoxycyclohexyl)ethylethyldiethoxysilane, β-(3,4-epoxycyclohexyl)ethyldiethylethoxysilane, 3-epoxypropyltrimethoxysilane, 3-epoxypropyltriethoxysilane, 3-epoxypropylmethyldimethoxysilane, 3-epoxypropyldimethylmethoxysilane, 3-epoxypropylmethyldiethoxysilane, 3-epoxypropyldimethylethoxysilane, 3-epoxypropylethyldimethoxysilane, 3-epoxypropyldiethylmethoxysilane, 3-epoxypropylethyldiethoxysilane, 3-epoxypropyldiethylethoxysilane, 4-epoxybutyryltrimethoxysilane, 6-epoxyhexyltrimethoxysilane, 8-epoxyoctyltrimethoxysilane, 4-epoxybutyryltriethoxysilane, 6-epoxyhexyltriethoxysilane and 8-epoxyoctyltriethoxysilane.

Titanate coupling agents are exemplified by titanium acylates, titanium acylate polymers, titanium phosphate polymers and titanium alcoholates.
The above coupling agents may be used singly or as combinations of two or more thereof.

Of the above coupling agents, for such reasons as good water resistance, adherence to the inorganic hydroxide, hardness of the applied coat, staining properties and pot life, the use of the following coupling agents are preferred: γ-glycidoxypropyltrimethoxysilane, γ-glycidoxypropylmethyldiethoxysilane, γ-glycidoxypropyltriethoxysilane, β-(3,4-epoxycyclohexyl)ethyltrimethoxysilane, β-(3,4-epoxycyclohexyl)ethyltriethoxysilane, γ-aminopropyltrimethoxysilane, γ-aminopropyltriethoxysilane, N-β-(aminoethyl)-γ-aminopropyltrimethoxysilane, N-β-(aminoethyl)-γ-aminopropyltriethoxysilane, γ-isocyanatopropyltrimethoxysilane and γ-isocyanatopropyltriethoxysilane.

The temperature of the reaction between the isocyanate group and the above coupling agent is generally in a range of from about -50 to about +200°C. However, to suppress reactions between the carbodiimide group and the coupling agent, a relatively low temperature in a range of from -30 to about +100°C, and especially from about -10 to about +50°C, is preferred.
The carbodiimide group and the coupling agent may be allowed to react, insofar as the performance of the carbodiimide group-containing organic layer is not thereby compromised.

In the carbodiimide compounds of above-described formulas (I), (1) and (2), the number of carbodiimide groups on the molecule is, on average, preferably from about 1 to about 100, and more preferably from 2 to 80. If the number of carbodiimide groups is less than 1, the compound may not exhibit to a sufficient degree the properties of a carbodiimide compound. On the other hand, if the number of carbodiimide groups is more than 100, synthesis will be possible but the compound will have a high molecular weight and may thus be difficult to handle.

The carbodiimide group-containing compound used in the flame retardant of the invention may be a (co)polymer which has at least one type of recurring unit from among those of formulas (3) and (4) below and which also has, if necessary, recurring units of formula (5) below. By having the compound be such a (co)polymer, the carbodiimide groups can be efficiently included within various types of polymer.

[Chemical Formula 1]

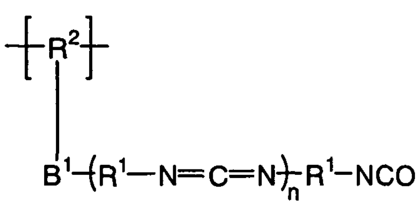

(3)

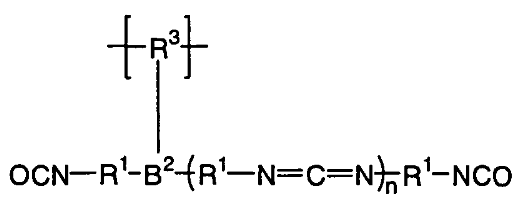

(4)

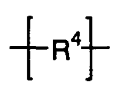

(5)

In the above formulas, $R^2$ is a monomer-derived partial structure having both a group capable of reacting with an isocyanate group and a polymerizable functional group, and $B^1$ is a bonding group which is formed by the reaction of a isocyanate group with a group capable of reacting with the isocyanate group. $R^3$ is a monomer-derived partial structure having both a group capable of reacting with a carbodiimide group and a polymerizable functional group, and $B^2$ is a bonding group which is formed by the reaction of a carbodiimide group with a group capable of reacting with the carbodiimide group. $R^4$ is a monomer-derived partial structure which has a polymerizable functional group but lacks a functional group capable of reacting with an isocyanate group or a carbodiimide group. $R^1$ and the letter n are the same as mentioned above.

$R^2$ is a partial structure which can be obtained by the reaction of a monomer having both a group capable of reacting with an isocyanate group and a polymerizable functional group with an isocyanate group, and also by polymerization using the polymerizable functional groups. $R^2$ forms the main chain on a (co)polymer. The functional group capable of reacting with an isocyanate group is exemplified by hydroxyl groups, primary or secondary amino groups, carboxyl groups and thiol groups.

$R^3$ is a partial structure which can be obtained by the reaction of a monomer having both a group capable of reacting with a carbodiimide group and a polymerizable functional group with a carbodiimide group, and polymerization using the polymerizable functional groups. $R^3$ forms the main chain on a (co)polymer. The functional group capable of reacting with a carbodiimide group is exemplified by hydroxyl groups, amino groups (preferably primary or secondary), carboxyl groups, thiol groups, isocyanate groups, epoxy groups, urethane bonds, urea bonds, amide bonds and acid anhydride.

The polymerizable functional groups in $R^2$, $R^3$ and $R^4$ are not subject to any particular limitation. However, based on such considerations as polymerizability and the simplicity of the reaction operations, it is preferable for these groups to be polymerizable double bonds.

Specific examples of monomers having a group capable of reacting with an isocyanate group or a carbodiimide group and having also a polymerizable functional group include 2-hydroxyethyl acrylate, 2-hydroxyethyl methacrylate, 2-hydroxylpropyl acrylate, 2-hydroxylpropyl methacrylate, pentaerythritol triacrylate, pentaerythritol trimethacrylate, glycidyl acrylate, glycidyl methacrylate, allyl alcohol, 3-buten-1-ol, 4-penten-1-ol, allylamine, N-methylallylamine, N-ethyl-2-methylallylamine, diallylamine, allylcyclohexylamine, butadiene monoxide, 1,2-epoxy-5-hexene, 1,2-epoxy-7-octene, allyl glycidyl ether, 2-allylphenol, 2-allyloxyethanol, pentaerythritol triallyl ether, polyethylene glycol monomethacrylate, polypropylene glycol monomethacrylate, polyethylene glycol monoacrylate, 2-sulfoethyl methacrylate, polyethylene glycol monoarylate, 2-hydroxy-1,3-dimethacryloxypropane and polypropylene glycol monoacrylate. These may be used singly or as combinations of two or more thereof.

$R^4$ is a partial structure which can be obtained by using the polymerizable functional group on a monomer having both a polymerizable functional group and a functional group capable of reacting with an isocyanate group and a carbodiimide group to polymerize the monomer. $R^4$ forms the main chain on a (co)polymer. This monomer is an optional ingredient that may be used as needed.

Illustrative examples of such monomers having a polymerizable functional group and a functional group capable of reacting with an isocyanate group and a carbodiimide group include olefins such as ethylene and propylene; styrene compounds such as styrene, o-methylstyrene, m-methylstyrene, p-methylstyrene, $\alpha$-methylstyrene, p-ethylstyrene, 2,4-dimethylstyrene, p-n-butylstyrene, p-t-butylstyrene, p-n-hexyl styrene, p-n-octylstyrene, p-n-nonylstyrene, p-n-decylstyrene, p-n-dodecylstyrene, p-methoxystyrene, p-phenylstyrene, p-chlorostyrene and 3,4-dichlorostyrene; (meth)acrylic acid derivatives such as methyl acrylate, ethyl acrylate, n-butyl acrylate, isobutyl acrylate, propyl acrylate, hexyl acrylate, 2-ethylhexyl acrylate, n-octyl acrylate, dodecyl acrylate, lauryl acrylate, stearyl acrylate, 2-chloroethyl acrylate, phenyl acrylate, methyl $\alpha$-chloroacrylate, methyl methacrylate, ethyl methacrylate, n-butyl methacrylate, isobutyl methacrylate, propyl methacrylate, hexyl methacrylate, 2-ethylhexyl methacrylate, n-octyl methacrylate, dodecyl methacrylate, lauryl methacrylate, stearyl methacrylate, (meth)acrylonitrile, (meth)acrylate and methyl (meth)acrylate; vinyl ethers such as vinyl methyl ether, vinyl ethyl ether and vinyl isobutyl ether; vinyl ketones such as vinyl methyl ketone, vinyl hexyl ketone and methyl isopropenyl ketone; N-vinyl compounds such as N-vinylpyrrole, N-vinylcarbazole, N-vinylindole and N-vinylpyrrolidone; fluorinated alkyl group-containing compounds such as vinyl fluoride, vinylidene fluoride, tetrafluoroethylene, hexafluoropropylene, trifluoroethyl acrylate and tetrafluoropropyl acrylate; and halogenated organic compounds such as ethyl bromide, (S)-3-bromo-3-methylhexane and chloromethane. These may be used singly or as combinations of two or more thereof. Of these, based on such considerations as versatility and reactivity, the use of styrene compounds and (meth)acrylic acid derivatives is preferred. Styrene and methyl methacrylate are especially preferred.

In the (co)polymer which has at least one type of recurring unit of above formulas (3) and (4) and which also has, if necessary, recurring units of above formula (5), the number of carbodiimide groups present on the molecule is, on average, preferably from about 1 to about 100, and more preferably from 2 to 80. If the number of carbodiimide groups is less than 1, the compound may not exhibit to a sufficient degree the properties of a carbodiimide group-containing compound. On the other hand, if the number of carbodiimide groups is more than 100, synthesis will be possible but the compound will have a high molecular weight and may thus be difficult to handle.

The above (co)polymer has a weight-average molecular weight of preferably from 1,000 to 1,000,000, more preferably

from 2,500 to 950,000, even more preferably from 5,000 to 500,000, and most preferably from 10,000 to 300,000.

The agglomerating properties of the flame retardant and its dispersibility in organic resins may be controlled by, for example, changing the composition of the various above-described carbodiimide group-containing compounds, adjusting their molecular weights, or modifying the end-capping segments (in the case of compounds of formulas (I), (1), (3) and (4)). All of the isocyanate groups on the carbodiimide group-containing compound may be capped, although it is also possible to allow an isocyanate group to remain at one or both ends.

Illustrative examples of ordinary compounds which are capable of serving as capping agents; i.e., which react with isocyanate groups, are given below.

(a) Hydroxyl (OH) Group-containing Compounds

Examples of hydroxyl group-containing compounds include

(i) primary alcohols such as methanol, ethanol, 1-propanol, 2-propanol, n-butanol, sec-butanol, tert-butanol, n-octanol and n-dodecyl alcohol;
(ii) saturated or unsaturated glycols such as ethylene glycol, propylene glycol, trimethylolpropane, pentaerythritol, 1,2-propanediol, 1,3-propanediol, 1,3-butanediol, 1,4-butanediol, neopentyl glycol, pentanediol, hexanediol, octanediol, 1,4-butenediol, diethylene glycol, triethylene glycol and dipropylene glycol;
(iii) cellosolves such as methyl cellosolve, ethyl cellosolve and butyl cellosolve;
(iv) (meth)acrylic monomers such as 2-hydroxyethyl (meth)acrylate, 2-hydroxypropyl (meth)acrylate, 3-hydroxypropyl (meth)acrylate and 4-hydroxybutyl (meth)acrylate;
(v) polyalkylene glycol (meth)acrylic compounds such as polyethylene glycol mono(meth)acrylate and polypropylene glycol mono(meth)acrylate;
(vi) various hydroxyalkyl vinyl ethers such as hydroxyethyl vinyl ether and hydroxybutyl vinyl ether;
(vii) various allyl compounds such as allyl alcohol and 2-hydroxyethyl allyl ether; (viii) alkyl glycidyl ethers such as n-butyl glycidyl ether and 2-ethylhexyl glycidyl ether; and
(ix) hydroxyl group-containing polymers such as polyethylene glycol and polypropylene glycol.

These may be used singly or as combinations of two or more thereof.

(b) Mercapto Group-containing Compounds:

Examples of mercapto group-containing compounds include

(i) aliphatic alkyl monofunctional thiols such as methanethiol, ethanethiol, n- or isopropanethiol, n- or iso-butanethiol, pentanethiol, hexanethiol, heptanethiol, octanethiol, nonanethiol, decanethiol and cyclohexanethiol;
(ii) aliphatic thiols having a heterocycle, such as 1,4-dithian-2-thiol, 2-(1-mercaptomethyl)-1,4-dithian, 2-(1-mercaptoethyl)-1,4-dithian, 2-(1-mercaptopropyl)-1,4-dithian, 2-(mercaptobutyl)-1,4-dithian, tetrahydrothiophen-2-thiol, tetrahydrothiophen-3-thiol, pyrrolidin-2-thiol, pyrrolidin-3-thiol, tetrahydrofuran-2-thiol, tetrahydrofuran-3-thiol, piperidin-2-thiol, piperidin-3-thiol and piperidin-4-thiol;
(iii) aliphatic thiols having a hydroxyl group, such as 2-mercaptoethanol, 3-mercaptopropanol and thioglycerol;
(iv) compounds having an unsaturated double bond, such as 2-mercaptoethyl (meth)acrylate, 2-mercapto-1-carboxyethyl (meth)acrylate, N-(2-mercaptoethyl)acrylamide, N-(2-mercapto-1-carboxyethyl)acrylamide, N-(2-mercaptoethyl)methacrylamide, N-(4-mercaptophenyl)acrylamide, N-(7-mercaptonaphthyl)acrylamide and mono(2-mercaptoethylamide) maleate;
(v) aliphatic dithiols such as 1,2-ethanedithiol, 1,3-propanedithiol, 1,4-butanedithiol, 1,6-hexanedithiol, 1,8-octanedithiol, 1,2-cyclohexanedithiol, ethylene glycol bisthioglycolate, ethylene glycol bisthiopropionate, butanediol bisthioglycolate, butanediol bisthiopropionate, trimethylolpropane tristhioglycolate, trimethylolpropane tristhiopropionate, pentaerythritol tetrakisthioglycolate, pentaerythritol tetrakisthiopropionate, tris(2-mercaptoethyl)isocyanurate and tris(3-mercaptopropyl)isocyanurate;
(vi) aromatic dithiols such as 1,2-benzenedithiol, 1,4-benzenedithiol, 4-methyl-1,2-benzenedithiol, 4-butyl-1,2-benzenedithiol and 4-chloro-1,2-benzenedithiol; and
(vii) mercapto group-bearing polymers such as mercapto group-bearing modified polyvinyl alcohols.

These may be used singly or as combinations of two or more thereof.

(c) Amino Group-containing Compounds:

Examples of amino group-containing compounds include

(i) aromatic amino group-bearing compounds such as ammonia, methylamine, ethylamine, n-propylamine, isopropylamine, monoethanolamine, n-propanolamine, isopropanolamine, aniline, cyclohexylamine, n-butylamine, n-pentylamine, n-hexylamine, n-heptylamine, n-octylamine, n-nonylamine, n-decylamine, n-undecylamine, n-dodecylamine, n-tridecylamine, n-tetradecylamine, n-pentadecylamine, cyclohexylamine, n-hexadecylamine, n-heptadecylamine, n-octadecylamine, n-eicosylamine, diethylamine, diethanolamine, dibutylamine, di-n-propanolamine, diisopropanolamine, N-methylethanolamine and N-ethylethanolamine;
(ii) alkylamino acrylates such as dimethylaminoethyl acrylate, diethylaminoethyl acrylate, dimethylaminomethyl acrylate, diethylaminomethyl acrylate, addition products of diacrylate and diethylamine, and addition products of trimethylolpropane triacrylate and diethylamine;
(iii) alkylaminoalkyl vinyl ethers such as (meth)acrylamide, $\alpha$-ethyl (meth)acrylamide, N-methyl (meth)acrylamide, N-butoxymethyl (meth)acrylamide, diacetone (meth)acrylamide, N,N-dimethyl (meth)acrylamide, N,N-diethyl (meth) acrylamide, N,N-dimethyl p-styrenesulfonamide, N,N-dimethylaminoethyl (meth)acrylate, N,N-diethylaminoethyl (meth)acrylate, N,N-dimethylaminopropyl (meth)acrylate, N,N-diethylaminopropyl (meth)acrylate, N-[2-(meth)acryloyloxyethyl]piperidine, N-[2-(meth)acryloyloxyethylene]pyrrolidine, N-[2-(meth)acryloyloxyethyl]morpholine, 4-(N, N-dimethylamino)styrene, 4-(N,N-diethylamino)styrene, 4-vinylpyridine, 2-dimethylaminoethyl vinyl ether, 2-diethylaminoethyl vinyl ether, 4-dimethylaminobutyl vinyl ether, 4-diethylaminobutyl vinyl ether and 6-dimethylaminohexyl vinyl ether; and
(iv) amino group-containing polymers.
These may be used singly or as combinations of two or more thereof.

(d) Carboxyl Group-containing Compounds:

Examples of carboxyl group-containing compounds include

(i) saturated aliphatic monocarboxylic acids, including fatty acids and higher fatty acids, such as formic acid, acetic acid, propionic acid, isovaleric acid, hexanoic acid, lauric acid, myristic acid, palmitic acid, stearic acid, arachic acid, oleic acid, linoleic acid and linolenic acid;
(ii) saturated aliphatic dicarboxylic acids such as oxalic acid, malonic acid and succinic acid;
(iii) organic carboxylic acids having an ester group, such as 2-acryloyloxyethylsuccinic acid and 3-acryloyloxypropylphthalic acid;
(iv) carbocyclic carboxylic acids such as benzoic acid, toluic acid and salicylic acid;
(v) heterocyclic carboxylic acids such as furancarboxylic acid, thiophenecarboxylic acid and pyridinecarboxylic acid;
(vi) unsaturated mono- or dicarboxylic acids or unsaturated dibasic acids, such as acrylic acid, methacrylic acid, crotonic acid, itaconic acid, maleic acid, fumaric acid, monobutyl itaconate and monobutyl maleate;
(vii) carboxylic acid-derived acid anhydrides, such as acetic anhydride, succinic anhydride and phthalic anhydride; and (viii) polymeric carboxylic acids such as polyacrylic acid and polymethacrylic acid. These may be used singly or as combinations of two or more thereof.

(e) Isocyanate Group-containing Compounds:

Examples of isocyanate group-containing compounds include

(i) isocyanate compounds such as cyclohexyl isocyanate, n-decyl isocyanate, n-undecyl isocyanate, n-dodecyl isocyanate, n-tridecyl isocyanate, n-tetradecyl isocyanate, n-pentadecyl isocyanate, n-hexadecyl isocyanate, n-heptadecyl isocyanate, n-octadecyl isocyanate, n-eicosyl isocyanate, phenyl isocyanate and naphthyl isocyanate; and
(ii) isocyanate compounds having two or more isocyanate groups of the type used in carbodiimide compounds.

(f) Epoxy Group-containing Compounds

Example of epoxy group-containing compounds include

(i) glycidyl ethers of aliphatic polyols, such as neopentyl glycol diglycidyl ether, 1,6-hexanediol diglycidyl ether, ethylene glycol diglycidyl ether, propylene glycol diglycidyl ether, hexamethylene glycol diglycidyl ether, cyclohexanediol diglycidyl ether, glycerol triglycidyl ether, trimethylolpropane triglycidyl ether and pentaerythritol tetraglycidyl ether;
(ii) glycidyl ethers of polyalkylene glycols, such as polyethylene glycol diglycidyl ether, polypropylene glycol diglycidyl ether and polytetramethylene glycol diglycidyl ether;
(iii) polyester resin-based polyglycidyl compounds;
(iv) polyamide resin-based polyglycidyl compounds;
(v) bisphenol A-based epoxy resins;
(vi) phenol-novolak-based epoxy resins;
(vii) epoxyurethane resins; and
(viii) epoxy group-containing monomers such as glycidyl (meth)acrylate, (β-methyl)glycidyl (meth)acrylate, 3,4-epoxycyclohexyl (meth)acrylate, allyl glycidyl ether, 3,4-epoxyvinylcyclohexane, di(β-methyl)glycidyl maleate and di(β-methyl)glycidyl fumarate.

Use can be made of commercial epoxy group-containing compounds, examples of which include the following Denacol series products: Denacol EX-611, -612, -614, -614B, -622, -512, -521, -411, -421, -313, -314, -321, -201, -211, -212, -252, -810, -811, -850, -851, -821, -830, -832, -841, -861, -911, -941, -920, -931, -721, -111, -212L, -214L, -216L, -321L, -850L, -1310, -1410, -1610 and -610U (all products of Nagase ChemteX Corporation).
Alternatively, a water-soluble carbodiimide compound may be used to reduce the impact on the environment. Examples of water-soluble carbodiimide compounds include those having hydrophilic segments at the ends of the carbodiimide compound. At least one type of residue from among those shown below may be used as the hydrophilic segment.

(g) Alkylsulfonate Residues of Formula (6) Having At Least One Reactive Hydroxyl Group

$$R^6\text{-}SO_3\text{-}R^5\text{-}OH \qquad (6)$$

In the above formula, $R^5$ is an alkylene group of from 1 to 10, and $R^6$ is an alkali metal.
Examples of alkylsulfonates include sodium hydroxyethanesulfonate and sodium hydroxypropanesulfonate. Of these, sodium hydroxypropanesulfonate is preferred.

(h) Quaternary Salts of Dialkylaminoalcohol Residues of Formula (7)

$$(R^7)_2\text{-}N\text{-}R^8\text{-}OH \qquad (7)$$

In the above formula, $R^7$ is a lower alkyl group of 1 to 4 carbons, and $R^8$ is an alkylene or oxyalkylene group of 1 to 10 carbons.
Examples of dialkylaminoalcohols include 2-dimethylaminoethanol, 2-diethylaminoethanol, 3-dimethylamino-1-propanol, 3-diethylamino-1-propanol, 3-diethylamino-2-propanol, 5-diethylamino-2-propanol and 2-(di-n-butylamino)ethanol. Of these, 2-dimethylaminoethanol is preferred.

(i) Amine Residues of Formula (8)

$$(R^7)_2\text{-}NR'\text{-}R^8\text{-}OH \qquad (8)$$

In the above formula, $R^7$ and $R^8$ are the same as in Formula (7) above, and R' is a group from a quaternizing agent. Examples of quaternizing agents include dimethylsulfuric acid and methyl p-toluenesulfonate.

(j) Alkoxy Group End-Capped Poly(Alkyleneoxide) Residues of Formula (9) Having At Least One Reactive Hydroxyl Group

$$R^9\text{-}(O\text{-}CHR^{10}\text{-}CH_2)_o\text{-}OH \qquad (9)$$

In the above formula, $R^9$ is a lower alkyl group of 1 to 4 carbons, $R^{10}$ is a hydrogen atom or a methyl group; and the letter o is an integer from 2 to 30.
Examples of poly(alkylene oxides) include poly(ethylene oxide) monomethyl ether, poly(ethylene oxide) monoethyl ether, poly(ethylene oxide-propylene oxide) monomethyl ether and poly(ethylene oxide-propylene oxide) monoethyl ether. Of these, poly(ethylene oxide) monomethyl ether is preferred.

The above-described compounds which react with an isocyanate group may be used singly or as combinations of two or more thereof.
The compounds which react with an isocyanate group are not limited to the typical compounds mentioned in (a) to (j) above. Use may also be made of other compounds (e.g., acid anhydrides) having a functional group or bonding group which reacts with an isocyanate group.

In electronic material applications in particular, given the nature of the flame retardant and the need for compositions obtained by adding the flame retardant to an organic resin to have a good formability, not only must the flame retardant have a high dispersibility in organic resins and organic solvents, it is also very important that the flame retardant have the acid resistance required for etching treatment and that it be water-resistant so as to prevent adverse effects on such electrical characteristics as the dielectric constant, conductivity, and migration resistance. For these reasons, it is preferable for the end-capping segment to be lipophilic rather than hydrophilic, and for the compound obtained to not be water-soluble.
Preferred end-capping agents for obtaining the above compound include hydroxyl group-containing compounds such as methanol, ethanol, propanol, dodecyl alcohol and octanol; carboxyl group-containing compounds such as oxalic acid, salicylic acid, lauric acid, myristic acid, palmitic acid, stearic acid, arachic acid, oleic acid, linoleic acid and linolenic acid; isocyanate compounds such as cyclohexyl isocyanate, n-dodecyl isocyanate, n-octadecyl isocyanate, phenyl isocyanate and naphthyl isocyanate; mercapto group-containing compounds such as methanethiol, ethanethiol and propanethiol; and amino group-containing compounds such as ammonia, methylamine, ethylamine, dibutylamine, cyclohexylamine and n-dodecylamine. However, from the standpoint of dispersibility in resins and production costs, the use of dodecyl alcohol, octanol, dibutylamine, cyclohexylamine; a carboxyl group-containing compound such as lauric acid, myristic acid, palmitic acid, stearic acid, arachic acid or oleic acid; or an isocyanate compound such as phenyl isocyanate is especially preferred.

The flame retardant of the invention (referring here and below to an inorganic hydroxide having a carbodiimide group-containing organic layer), for good dispersibility of the flame retardant in organic solvents or organic resins, preferably satisfies the following relationship when tetrahydrofuran (THF) is used as the dispersing medium.
That is, the inorganic hydroxide having the carbodiimide group-containing organic layer has a particle size distribution with a standard deviation ($A_2$) which satisfies the following relationship with respect to a standard deviation ($A_1$) of the particle size distribution for a surface-untreated inorganic hydroxide: $(A_2)/(A_1) \leq 1.0$.

Similarly, for good dispersibility of the flame retardant in an organic solvent or organic resin, the inventive flame retardant preferably satisfies the following relationship when THF is used as the dispersing medium.
That is, the inorganic hydroxide having the carbodiimide group-containing organic layer has a volume mean particle diameter ($M_2$) which satisfies the following relationship with respect to a volume mean particle diameter ($M_1$) of a surface-untreated inorganic hydroxide: $(M_2)/(M_1) \leq 1.0$.

In addition, for reasons having to do with the lipophilicity of the flame retardant, the dispersibility of the flame retardant in an organic resin when producing molded articles, and the physical properties after molding, it is preferable for the inventive flame retardant to satisfy the following relationship when water with a pH of 7 is used as the dispersing medium.
That is, the inorganic hydroxide having the carbodiimide group-containing organic layer has a particle size distribution with a standard deviation ($A_4$) which satisfies the following relationship with respect to a standard deviation ($A_3$) of the particle size distribution for a surface-untreated inorganic hydroxide: $(A_4)/(A_3) > 1.0$.
For such reasons as good dispersibility in the organic resin during molding and good physical properties after molding, it is even more preferable for $(A_4)/(A_3) > 1.5$, and most preferable for $(A_4)/(A_3) > 1.8$.

Similarly, for reasons having to do with the lipophilicity of the flame retardant, the dispersibility of the flame retardant in an organic resin when producing molded articles, and the physical properties after molding, it is preferable for the inventive flame retardant to satisfy the following relationship when water with a pH of 7 is used as the dispersing medium.
That is, the inorganic hydroxide having the carbodiimide group-containing organic layer has a volume mean particle diameter ($M_4$) which satisfies the following relationship with respect to the volume mean particle diameter ($M_3$) of a surface-untreated inorganic hydroxide: $(M_4)/(M_3) > 1.0$.
For such reasons as good dispersibility in the organic resin during molding and good physical properties after molding, it is even more preferable for $(M_4)/(M_3) > 1.2$, and most preferable for $(M_4)/(M_3) > 1.5$.

The volume mean particle diameter above is a value measured with a laser diffraction/scattering-type or dynamic

light scattering-type particle size analyzer. More specifically, the volume mean particle diameter is a value measured using a specimen having a concentration capable of being measured with the particle size analyzer to be used, which specimen has been prepared by adding the inorganic hydroxide to and dispersing it in THF or pH 7 water.
Here, the standard deviation, which is a measure of the width in the distribution of the measured particle size, is the value calculated by the following formula.

$$\text{Standard deviation} = (d84\% - d16\%)/2$$

where

d84%: volume mean particle diameter (μm) at 84% of cumulative curve

d16%: volume mean particle diameter (μm) at 16% of cumulative curve

As used herein, "surface-untreated inorganic hydroxide" refers to inorganic hydroxide which does not have a carbodiimide group-containing organic layer and has not been subjected to any other surface modification (i.e., which has not been treated with a surface treatment agent). The inorganic hydroxide making up the surface-untreated inorganic hydroxide and the inorganic hydroxide making up the inorganic hydroxide having a carbodiimide group-containing organic layer thereon are identical.

A method for preparing the flame retardant of the invention is described below.
The carbodiimide group-containing organic layer in the invention may be a layer composed only of a carbodiimide group-containing compound or a layer obtained by providing carbodiimide groups to a layer composed of an organic compound which contains no carbodiimide groups.
As used herein, "a layer obtained by providing carbodiimide groups to a layer composed of an organic compound which contains no carbodiimide groups" refers to a layer obtained by grafting a carbodiimide group-containing compound onto an organic layer which contains no carbodiimide groups, or to a copolymer layer composed of an organic compound having no carbodiimide groups and a carbodiimide group-containing compound.

In the practice of the invention, the formation of an organic layer composed of the above carbodiimide group-containing compound on a surface of the inorganic hydroxide may involve directly or indirectly bonding a functional group, an ionic component or a surface charge present on the inorganic hydroxide itself with the carbodiimide group-containing compound via a chemical bond such as a covalent bond, hydrogen bond, coordinate bond or ionic bond.
The reaction between the inorganic hydroxide and the carbodiimide group-containing compound may be suitably selected from among known techniques depending on the type of bond. Illustrative examples include methods in which first the compound of above formula (I), (1) or (2) or the (co)polymer containing recurring units of formula (3) or (4) is prepared by polymerization, following which these are chemically bonded to an inorganic hydroxide surface. Examples of chemical bonds between the inorganic hydroxide surface and the carbodiimide group-containing compound include covalent bonds, hydrogen bonds and coordinate bonds.
The bonding reaction between the inorganic hydroxide and the carbodiimide group-containing compound may be, for example, a dehydration reaction, a substitution reaction, an addition reaction, an adsorption reaction or a condensation reaction.
Covalent bonds are especially preferred because they create strong bonds between the inorganic hydroxide and the organic component.

When the organic layer is formed based on functional groups present in the inorganic hydroxide itself, the inorganic hydroxide surface may first be modified with a reactive functional group-containing compound. Through such surface modification, the bonds between the inorganic hydroxide and the carbodiimide group-containing organic layer can be made stronger.
Illustrative examples of such reactive functional groups include hydroxyl groups, amino groups (preferably primary or secondary), carboxyl groups, thiol groups, isocyanate groups, epoxy groups, urethane bonds, urea bonds, amide bonds, acid anhydrides, and polymerizable double bonds.

Any of various known methods may be employed as the method of modifying the inorganic hydroxide with a compound bearing such a reactive functional group, although it is convenient to use a method which involves treatment with a surface treatment agent that is appropriate for the functional group to be introduced.
Surface treatment agents include, but are not limited to, unsaturated fatty acids such as oleic acid; unsaturated fatty acid metal salts such as sodium oleate, calcium oleate and potassium oleate; unsaturated fatty acid esters; unsaturated fatty acid ethers; surfactants; silane coupling agents such as vinyltrimethoxysilane, 3-aminopropyltriethoxysilane, 3-glycidoxypropyltrimethoxysilane, methacryloxymethyltrimethoxysilane, methacryloxypropyltrimethoxysilane, 3-mercaptopropyltrimethoxysilane and 3-chloropropyltrimethoxsilane; and titanate coupling agents such as titanium acylates and titanium alcoholates.
In some cases, the carbodiimide group-containing compounds of formulas (1) and (2) may have a reactivity similar to that of a silane coupling agent or a titanate coupling agent. The advantage in such cases is that a carbodiimide group-containing organic layer may be efficiently formed on the inorganic hydroxide surface without surface treating the inorganic hydroxide.

Another way to form an organic layer composed of the above carbodiimide group-containing compound on the inorganic hydroxide surface involves carrying out a polymerization reaction at the inorganic hydroxide surface so as to form a (co)polymer layer. Illustrative, non-limiting, examples of such techniques include the following.

(a) A process in which (co)polymerization of a starting monomer that provides carbodiimide group-containing recurring units of formulas (3) and/or (4) (and, if necessary, a monomer that provides recurring units of formula (5)) is carried out at the inorganic hydroxide surface, thereby chemically bonding the (co)polymer to the inorganic hydroxide surface, and the (co)polymer chains are extended so as to form a carbodiimide group-containing organic layer.

(b) A process in which (co)polymerization of a monomer without carbodiimide groups is carried out at the inorganic hydroxide surface so as to chemically bond the (co)polymer and the inorganic hydroxide, following which the groups on the (co)polymer which are capable of reacting with isocyanate groups or carbodiimide groups are reacted with the isocyanate groups or carbodiimide groups on a carbodiimide group-containing organic compound, thereby forming a carbodiimide group-containing organic layer having structural units of formulas (3) and (4).

In process (a), first a monomer having a group capable of reacting with an isocyanate group or a carbodiimide group and having also a polymerizable functional group is reacted with, for example, a carbodiimide group-containing compound of formula (I), thereby forming a starting monomer which provides recurring units of formulas (3) and/or (4). Next, this starting monomer (and, if necessary, a starting monomer which provides recurring units of formula (5)) is (co) polymerized at the surface of the inorganic hydroxide. This (co)polymer is chemically bonded to the inorganic hydroxide surface, in addition to which the carbodiimide group-containing compound chains are extended, thereby forming a carbodiimide group-containing organic layer (commonly referred to as a "grafting from" technique).
In process (b), first a monomer having a group capable of reacting with an isocyanate group or a carbodiimide group and having also a polymerizable functional group is (co)polymerized at the inorganic hydroxide surface and thereby chemically bonded to the inorganic hydroxide surface, in addition to which the polymer chains are extended, thereby forming a carbodiimide group-containing organic layer. Next, the groups present on the organic compound layer which are capable of reacting with an isocyanate group or a carbodiimide group are reacted with, for example, a carbodiimide compound of formula (I), thereby forming a carbodiimide group-containing organic layer (commonly referred to as a "grafting from" technique).

The (co)polymerization method is exemplified by addition polymerization, polycondensation, hydrogen transfer polymerization and addition condensation.
Examples of addition polymerization include radical polymerization, ionic polymerization, oxidative anionic polymerization and ring-opening polymerization. Examples of polycondensation include elimination polymerization, dehydrogenation polymerization and denitrogenation polymerization. Examples of hydrogen transfer polymerization include polyaddition, isomerization polymerization and group transfer polymerization.
Radical polymerization is especially preferred because it is simple and very cost-effective, and is commonly used for the industrial synthesis of various polymers. Living radical polymerization, while not yet widely used in industry, is especially useful in that it facilitates control of the molecular weight, molecular weight distribution and grafting density of the polymer.

The polymerization conditions are not subject to any particular limitation. Various known conditions may be employed according to such factors as the monomer being used.
For example, when grafting is effected by carrying out radical polymerization at the surface of the inorganic hydroxide, the amount of monomer having functional groups capable of reacting therewith per 0.1 mol of reactive functional groups present on or introduced onto the inorganic hydroxide is generally from 1 to 300 moles, and the amount of polymerization initiator used is generally from 0.005 to 30 moles. The polymerization temperature is generally from -20 to 1,000°C, and the polymerization time is generally from 0.2 to 72 hours.
If necessary, various additives such as dispersants, stabilizers and emulsifiers (surfactants) may be added to the polymerization reaction system at the time that polymerization is carried out.

Initiators that may be used in radical polymerization are not subject to any particular limitation, and may be suitably selected from among known radical polymerization initiators. Examples include, but are not limited to, peroxides such as benzoyl peroxide, cumene hydroperoxide, t-butyl hydroperoxide, sodium persulfate, potassium persulfate and ammonium persulfate; and azo compounds such as azobisisobutyronitrile, azobismethylbutyronitrile and azobisisovaleronitrile. These may be used singly or as combinations of two or more thereof.

The solvent used in polymerization is not subject to any particular limitation. Use may be made of any common solvent hitherto used in polymer synthesis.

Specific examples include, but are not limited to, ketones such as acetone, methyl ethyl ketone, methyl isobutyl ketone and cyclohexanone; esters such as ethyl acetate, butyl acetate, ethyl propionate and cellosolve acetate; aliphatic or aromatic hydrocarbons such as pentane, 2-methylbutane, n-hexane, cyclohexane, 2-methylpentane, 2,2-dimethylbutane, 2,3-dimethylbutane, heptane, n-octane, isooctane, 2,2,3-trimethylpentane, decane, nonane, cyclopentane, methylcyclopentane, methylcyclohexane, ethylcyclohexane, p-menthane, dicyclohexyl, benzene, toluene, xylene, ethylbenzene and anisole (methoxybenzene); halogenated hydrocarbons such as carbon tetrachloride, trichloroethylene, chlorobenzene and tetrabromoethane; ethers such as ethyl ether, dimethyl ether, trioxane and tetrahydrofuran; and acetals such as methylal and diethylacetal. These may be used singly or as combinations of two or more thereof.

In the invention, an ionic liquid may be used as the reaction solvent. Using an ionic liquid makes it possible to shorten the production time, in addition to which the amount of organic solvent used can be held to zero or a very low level. Moreover, because ionic liquids are reusable, they can increase the environmental compatibility and safety. In addition, by carrying out the above-described polymerization reaction in an ionic liquid, the thickness of the carbodiimide group-containing organic layer may be further increased, enabling a flame retardant having even better dispersibility in organic resins to be obtained.

As used herein, "ionic liquid" refers generically to liquid salts, and particularly salts which become liquid at or near room temperature. These are solvents composed entirely of ions.

The ionic liquid used in the invention, while not subject to any particular limitation, is preferably one in which the cations making up the ionic liquid are of at least one type selected from among ammonium cations, imidazolium cations and pyridinium cations. Of these, ammonium cations are especially preferred.

Imidazolium cations are exemplified by, but not limited to, dialkylimidazolium cations and trialkylimidazolium cations. Specific examples include the 1-ethyl-3-methylimidazolium ion, 1-butyl-3-methylimidazolium ion, 1,2,3-trimethylimidazolium ion, 1,2-dimethyl-3-ethylimidazolium ion, 1,2-dimethyl-3-propylimidazolium ion and 1-butyl-2,3-dimethylimidazolium ion.

Examples of pyridinium cations include, but are not limited to, the N-propylpyridinium ion, N-butylpyridinium ion, 1-butyl-4-methylpyridinium ion and 1-butyl-2,4-dimethylpyridinium ion.

Ammonium cations are exemplified by, but not limited to, those in which an aliphatic or an alicyclic quaternary ammonium ion serves as the cation component.

Illustrative, non-limiting, examples of such aliphatic or alicyclic quaternary ammonium ions include such quaternary alkylammonium ions as the trimethylpropylammonium ion, trimethylhexylammonium ion, tetrapentylammonium ion, diethylmethyl(2-methoxyethyl)ammonium ion and diethylmethyl(2-methoxyethyl)ammonium ion; and also the N-butyl-N-methylpyrrolidinium ion and the N-(2-methoxyethyl)-N-methylpyrrolidinium ion.

The anion making up the above-described ionic liquid includes, but is not limited to, $BF_4^-$, $PF_6^-$, $AsF_6^-$, $SbF_6^-$, $A1Cl_4^-$, $HSO_4^-$, $ClO_4^-$, $CH_3SO_3^-$, $CF_3SO_3^-$, $CF_3CO_2^-$, $(CF_3SO_2)_2N^-$, $Cl^-$, $Br^-$ and $I^-$.

Preferred examples of the ionic liquid include, but are not limited to, the bis(trifluoromethanesulfonimide) salt of diethylmethyl(2-methoxyethyl)ammonium, the (tetrafluoroborate) salt of diethylmethyl(2-methoxyethyl)ammonium and the bis (trifluoromethanesulfonyl)imide salt of N-(2-methoxyethyl)-N-methylpyrrolidinium.

In the practice of the invention, the ionic liquid may be used alone or it may be used in admixture with any of various conventionally used solvents such as those mentioned above as polymerization reaction solvents.

When the ionic liquid is used in admixture with a conventional solvent, mixture may be carried out in any amount. However, to ensure the simplicity of subsequent treatment, environmental compatibility and safety, it is desirable for the concentration of ionic liquid in the mixed solvent to be at least 10 wt%, preferably at least 50 wt%, and more preferably from 80 to 100 wt%.

Still further methods of forming an organic layer composed of the carbodiimide group-containing compound on an inorganic hydroxide surface include a process in which the above-described organic isocyanate compound is copolymerized on the inorganic hydroxide surface in the presence of a catalyst which promotes the conversion of an isocyanate to a carbodiimide, thereby forming a carbodiimide group-containing organic layer; and a process in which the above-described organic isocyanate compound is polymerized on an inorganic hydroxide surface covered with an organic compound layer having groups capable of reacting with isocyanate groups or carbodiimide groups but lacking carbodiimide groups, and in the presence of a catalyst which promotes the conversion of isocyanate to carbodiimide, thereby forming a carbodiimide group-containing organic layer.

In the fire retardant of the invention, the carbodiimide group-containing organic layer is present in an amount of preferably at least 0.1 wt%, based on the inorganic hydroxide. In particular, taking into consideration the dispersibility of the fire retardant in organic resins and the electrical and mechanical characteristics of molded articles thereby obtained, the amount of the carbodiimide group-containing organic layer is more preferably at least 0.3 wt%, even more preferably at least 0.5 wt%, and most preferably at least 1.0 wt%.

The weight percent (wt%) of the carbodiimide group-containing organic layer is a calculated value obtained after first determining the respective volumes of the organic layer and the inorganic hydroxide per cubic centimeter of the organic layer-bearing inorganic hydroxide from density measurements taken with a gas pycnometer (Accupyc 1330, manufactured by Shimadzu Corporation; in helium).

The thickness of the carbodiimide group-containing organic layer is not subject to any particular limitation. However, taking into consideration the dispersibility of the fire retardant in organic resins and the electrical and mechanical characteristics of molded articles thereby obtained, although the thickness depends on such factors as the particle size, the type of carbodiimide resin and the surface area of coverage and therefore cannot be strictly specified, at a microscopic level it is preferably on average at least 1 nm, more preferably at least 2 nm, and even more preferably at least 3 nm. The thickness of the organic layer is a calculated value obtained after first determining the volume of the organic layer, the volume of the inorganic hydroxide and the total surface area per cubic centimeter of the flame retardant from density measurements taken with a gas pycnometer (Accupyc 1330, manufactured by Shimadzu Corporation; in helium). In the calculations, the flame retardant is assumed to be in the form of spherical particles.

Examples of the organic resin making up the inorganic/organic composite flame-retardant composition of the invention include, but are not limited to, thermoplastic resins such as polyolefin resins (e.g., polyethylene, polypropylene), polystyrene resins (e.g., polystyrene), polyvinyl halide derivative resins (e.g., polyvinyl chloride, polyvinylidene chloride), polyvinyl acetate derivative resins (e.g., polyvinyl acetate), poly(meth)acrylate resins (e.g., polymethyl methacrylate), polyvinyl ethers (e.g., polyvinyl methyl ether, polyvinyl ethyl ether, polyvinyl isobutyl ether), polyvinyl ketones (e.g., polyvinyl methyl ketone, polyvinyl hexyl ketone, polymethyl isopropenyl ketone), poly(N-vinyl) compounds (e.g., poly(N-vinylpyrrole), poly(N-vinylcarbazole), poly(N-vinylindole), poly(N-vinylpyrrolidone)), fluorocarbon resins, polyamides (e.g., nylon 6), polyesters, polycarbonates, silicones, polyacetals and acetyl cellulose; and thermoset resins such as epoxy resins, phenolic resins, urea resins, melamine resins, alkyd resins and unsaturated polyester resins.

Of these, from the standpoint of such considerations as environmental compatibility and the diversity of uses for the composition, it is preferable to use polystyrene resins, polyolefin resins, poly(meth)acrylate resins, vinyl carboxylate resins such as polyvinyl acetate, and epoxy resins.

No particular limitation is imposed on the proportions in which the flame retardant and the organic resin are compounded. However, to achieve a good balance between the various functionality-improving effects and the decline in physical properties which result from incorporation of the flame retardant, the weight ratio of the flame retardant (untreated inorganic hydroxide basis) to the organic resin is preferably from 5:95 to 90:10, more preferably from 10:90 to 80:20, and even more preferably from 15:85 to 85:15.

The composition may be prepared by using any suitable method to mix together the flame retardant and the organic resin. At the time of mixture, use may also be made of a solvent.

Examples of the solvent that may be used when preparing the composition include, but are not limited to, ketones such as acetone, methyl ethyl ketone, methyl isobutyl ketone and cyclohexanone; esters such as ethyl acetate, butyl acetate, ethyl propionate and cellosolve acetate; aliphatic or aromatic hydrocarbons such as pentane, 2-methylbutane, n-hexane, cyclohexane, 2-methylpentane, 2,2-dimethylbutane, 2,3-dimethylbutane, heptane, n-octane, isooctane, 2,2,3-trimethylpentane, decane, nonane, cyclopentane, methylcylopentane, methylcyclohexane, ethylcyclohexane, p-menthane, benzene, toluene, xylene and ethylbenzene; halogenated hydrocarbons such as carbon tetrachloride, trichloroethylene, chlorobenzene and tetrabromoethane; ethers such as ethyl ether, dimethyl ether, trioxane and tetrahydrofuran; acetals such as methylal and diethylacetal; and sulfur or nitrogen-containing organic compounds such as nitropropene, nitrobenzene, pyridine, dimethylformamide and dimethylsulfoxide. Based on such considerations as the solubility, moldability and molding efficiency of the organic resin, the use of a ketone, such as acetone, methyl ethyl ketone, methyl isobutyl ketone or cyclohexanone, or of toluene or tetrahydrofuran is most preferred. These may be used singly or as combinations of two or more thereof.

In the inventive composition, the flame retardant in one gram of the composition has a total surface area of preferably from 2,000 to 1,000,000 $cm^2$, more preferably from 4,000 to 600,000 $cm^2$, and even more preferably from 10,000 to 500,000 $cm^2$. For reasons having to do with the moldability and physical properties of the composition, the total surface area of the flame retardant in one gram of the composition is most preferably from 13,000 to 300,000 $cm^2$. As used herein, "total surface area" refers to a theoretical value obtained by arithmetically adding up the surface area for all of the flame retardant added to the organic resin. In determining the surface area, it is assumed that the flame retardant is in the form of spherical particles. The particle size refers to the volume mean particle diameter.

The flame retardant of the invention has an excellent dispersibility in organic resins and organic solvents. Moreover, because, even at high loadings in an organic resin, the flame retardant does not invite declines in the electrical characteristics, mechanical characteristics, heat resistance and water absorptivity of molded articles obtained therefrom, it can be included within the composition in a high proportion of 15 wt% or more that provides a total covered surface area of 2,000 $cm^2$ (per gram of composition) or more.

It is also preferable for the inorganic/organic composite flame-retardant composition of the invention to have a low coefficient of expansion. Moreover, the composition preferably has characteristics (1) to (6) below. In (1) to (3)

below, the organic resin used in both compositions is the same. Also, the term 'composition' as used in the present invention encompasses not only compositions of indefinite state obtained by merely mixing the flame retardant and the organic resin, but also shaped materials obtained by shaping such compositions.

(1) The inorganic/organic composite flame-retardant composition has a dielectric constant which satisfies the following relationship with respect to the dielectric constant of an untreated inorganic hydroxide-containing composition that includes, instead of the flame retardant in the inorganic/organic composite flame-retardant composition, a like amount (inorganic hydroxide basis) of an inorganic hydroxide lacking an organic layer: (dielectric constant of inorganic/organic composite flame-retardant composition)/(dielectric constant of untreated inorganic hydroxide-containing composition) < 1.0, and preferably < 0.99.
If this dielectric constant ratio is 1.0 or more, the carbodiimide group-containing organic layer formed on the surface of the inorganic hydroxide will have an insufficient dielectric constant increase-preventing effect.
The dielectric constant is measured at a frequency of 1 GHz using a dielectric constant measuring instrument (4291B Impedance Material Analyzer, manufactured by Agilent Technologies).

(2) The inorganic/organic composite flame-retardant composition has an elastic modulus which satisfies the following relationship with respect to the elastic modulus of an untreated inorganic hydroxide-containing composition that includes, instead of the flame retardant in the inorganic/organic composite flame-retardant composition, a like amount (inorganic hydroxide basis) of an inorganic hydroxide lacking an organic layer: (elastic modulus of inorganic/organic composite flame-retardant composition)/(elastic modulus of untreated inorganic hydroxide-containing composition) > 1.10, and preferably > 1.20.

At an elastic modulus ratio of 1.00 or less, shaped materials obtained by shaping the composition may have a lower mechanical strength. This is presumably a result of insufficient dispersibility of the flame retardant in the organic resin.
The elastic modulus is measured at room temperature using a thermal analysis/rheology system (EXTAR 600, manufactured by Seiko Instrument).

(3) The inorganic/organic composite flame-retardant composition has a bending stress which satisfies the following relationship with respect to the bending stress of an untreated inorganic hydroxide-containing composition that includes, instead of the flame retardant in the inorganic/organic composite flame-retardant composition, a like amount (inorganic hydroxide basis) of an inorganic hydroxide lacking an organic layer: (bending stress of inorganic/organic composite flame-retardant composition)/(bending stress of untreated inorganic hydroxide-containing composition) > 1.00, and preferably > 1.10.

At a bending stress ratio of 1.00 or less, shaped materials obtained by shaping the composition may have a lower mechanical strength. This is presumably a result of insufficient dispersibility of the flame retardant in the organic resin, and of a lower adherence between the flame retardant and the organic resin.

Although uses for the flame retardants and the inorganic/organic composite flame-retardant compositions of the invention are not subject to any particular limitation, preferred use of these can be made in materials requiring various types of functionality in such areas as electronic materials, building materials, and automotive materials.
Examples of such applications, primarily in the area of electronic materials, include printed circuit board materials for use in mainframe computers, automotive electronics, information and telecommunications system equipment, substrates with built-in capacitors, cellular phones, audiovisual equipment, office automation equipment, semiconductor packages, digital broadcasting receivers, base station power amplifiers, metal substrates for automotive mounting (substrates for electrical power steering), measuring instruments, capacitors, and network equipment such as servers and routers, as well as sealants for semiconductor packages, underfill sealants, and wire coating materials.

## EXAMPLES

The invention is illustrated more fully by way of the following Synthesis Examples, Examples of the invention, and Comparative Examples. It should be noted, however, that the invention is not limited by the Examples provided below.

[1] Synthesis of Carbodiimide Group-Containing Compounds Synthesis Example 1

A 300 ml three-necked flask was charged with 100 g of 4,4'-dicyclomethane diisocyanate (produced by Bayer; abbreviated below as "HMDI") and 0.5 g of 1-phenyl-2-phospholene-l-oxide (abbreviated below as "p-cat") was added as the catalyst, following which the flask contents were stirred for 24 hours at 180°C under nitrogen bubbling. The resulting carbodiimide compound was diluted with 35 g of toluene (Kanto Chemical Co., Ltd.) and cooled to 0°C, following which 40 g of 3-aminopropyltriethoxysilane (a silane coupling agent produced by Chisso Corporation) was slowly added dropwise under stirring. After 12 hours of reaction at 0°C in a nitrogen atmosphere, the isocyanate group peak in the IR spectrum for the carbodiimide compound was confirmed to have vanished and the reaction was stopped.

Synthesis Example 2

A 300 ml three-necked flask was charged with 100 g of 1,3-bis(1-isocyanato-1-methylethyl)benzene (produced by Takeda Chemical Industries, Ltd.; abbreviated below as "TMXDI") and 2.0 g of p-cat was added as the catalyst, following which the reaction was carried out for 12 hours at 180°C under nitrogen bubbling. Next, 0.6 g of aminostyrene (Wako Pure Chemical Industries, Ltd.) and 0.9 g of n-dodecylamine (Wako Pure Chemical Industries) were reacted with 10.0 g of the resulting carbodiimide compound for 5 hours at 0°C and under nitrogen.

[2] Flame Retardant (Inorganic Hydroxide Particles Having Carbodiimide Group-containing Organic Layer)

Example 1

$Mg(OH)_2$ (10.0 g; Kisuma 5Q, a surface-untreated $Mg(OH)_2$ produced by Kyowa Chemical Industry Co., Ltd.) having a volume mean particle diameter of 700 nm was thoroughly dispersed in 40.0 g of cyclohexanone (Wako Pure Chemical Industries) within a 100 ml round-bottomed flask, following which 0.03 g of 3-aminopropyltriethoxysilane (a silane coupling agent produced by Chisso Corporation) was added and the flask contents were stirred for 30 minutes at 65°C. Next, 0.5 g of 2,4-diisocyanatotoluene (Takeda Chemical Industries) and 0.02 g of p-cat as the catalyst were added and the flask contents were stirred for 1 hour at 65°C, after which 0.02 g of the catalyst p-cat and 0.12 g of n-dodecyl alcohol (Kanto Chemical) as an end-capping agent were added, and the system was heated at 70°C for about 15 hours to effect the reaction.
Following reaction completion, the $Mg(OH)_2$ particles were washed with tetrahydrofuran (abbreviated below as "THF"; Wako Pure Chemical Industries) and suction filtered four times to remove unreacted monomer and carbodiimide compound which had not bonded with the $Mg(OH)_2$ particles. After washing, the infrared spectrum of the particles was measured with an FT-IR8900 spectrometer (Shimadzu Corporation), whereupon absorption attributable to carbodiimide groups was observed near 2,200 $cm^{-1}$, confirming that the carbodiimide compound had chemically bonded to the magnesium hydroxide surface.
The volume mean particle diameter indicated above is a value that was measured using a particle size analyzer (MICROTRAC HRA 9320-X100, manufactured by Nikkiso Co., Ltd.).

Example 2

$Mg(OH)_2$ (10.0 g; Kisuma 5Q, surface-untreated $Mg(OH)_2$ produced by Kyowa Chemical Industry Co., Ltd.) having a volume mean particle diameter of 700 nm was thoroughly dispersed in 40.0 g of cyclohexanone (Wako Pure Chemical Industries) within a 100 ml round-bottomed flask, following which 1.0 g of the compound obtained in Synthesis Example 1 was added and the flask contents were stirred for 15 minutes at 65°C. Next, the $Mg(OH)_2$ particles were washed with tetrahydrofuran (abbreviated below as "THF"; Wako Pure Chemical Industries) and suction filtered two times to remove the compound obtained in Synthesis Example 1 which had not bonded with the $Mg(OH)_2$ particles. After washing, the infrared spectrum of the particles was measured with an FT-IR8900 spectrometer (Shimadzu Corporation), whereupon absorption attributable to carbodiimide groups was observed near 2,200 $cm^{-1}$, confirming that the carbodiimide compound obtained in Synthesis Example 1 had chemically bonded to the magnesium hydroxide particles. The carbodiimide compound had a degree of polymerization of 4.5.

Example 3

$Mg(OH)_2$ (10.0 g; Kisuma 5Q, surface-untreated $Mg(OH)_2$ produced by Kyowa Chemical Industry Co., Ltd.) having a volume mean particle diameter of 700 nm was thoroughly dispersed in 40.0 g of cyclohexanone within a 100 ml three-necked flask, following which 0.12 g of trimethoxysilane (a silane coupling agent produced by Chisso Corporation) was added to the resulting dispersion and the reaction was carried out at 65°C for 30 minutes. Next, 7.6 g of styrene

(Kanto Chemical), 0.4 g of methacrylic acid (Kanto Chemical) and 0.08 g of azobisisobutyronitrile (Kanto Chemical) as the initiator were added, and the reaction was carried out at 70°C for 15 hours.
Following reaction completion, the magnesium hydroxide particles were washed with THF and suction filtered four times to remove unreacted monomer and polymer which had not bonded to the $Mg(OH)_2$ particles. After washing, the infrared spectrum of the particles was measured with an FT-IR8900 spectrometer (Shimadzu Corporation), whereupon absorption attributable to carboxylic acid was observed near 1,720 $cm^{-1}$ and absorption attributable to benzene rings was observed near 700 $cm^{-1}$, confirming that a copolymer of a carboxylic acid and styrene had chemically bonded to the $Mg(OH)_2$ particles.

Next, 10 g of the above-described $Mg(OH)_2$ particles on which a polymer layer had been formed was thoroughly dispersed in 20 g of cyclohexanone (Daishin Chemicals Corporation) within a 50 ml three-necked flask, 0.3 g of TDI was added to the resulting dispersion, and the flask contents were stirred for 1 hour at 65°C. Next, 0.02 g of the catalyst p-cat and 0.12 g of n-dodecyl alcohol as an end-capping agent were added, and the reaction was carried out at 70°C for 15 hours. Following reaction completion, the $Mg(OH)_2$ particles were washed with THF and suction filtered, four times to remove unreacted monomer. After washing, the infrared spectrum of the particles was again measured, whereupon absorption attributable to carbodiimide groups newly appeared near 2,200 $cm^{-1}$. This confirmed that the carbodiimide compound had reacted with carboxyl groups in the copolymer of methacrylic acid and styrene, and was thereby grafted onto the styrene-methacrylic acid copolymer.

Example 4

$Mg(OH)_2$ (10.0 g; Kisuma 5Q, surface-untreated $Mg(OH)_2$ produced by Kyowa Chemical Industry Co., Ltd.) having a volume mean particle diameter of 700 nm was thoroughly dispersed in 40.0 g of cyclohexanone within a 100 ml three-necked flask, following which 0.12 g of 3-aminopropyltrimethoxysilane (a silane coupling agent produced by Chisso Corporation) was added to the resulting dispersion and the reaction was effected at 65°C for 30 minutes. Next, 7.6 g of styrene (Kanto Chemical), 9.5 g of the compound obtained in Synthesis Example 2, and 0.08 g of azobisisobutyronitrile (Kanto Chemical) as the initiator were added, and the reaction was carried out at 70°C for 15 hours.
Following reaction completion, the $Mg(OH)_2$ particles were washed with THF and suction filtered four times to remove polymer which had not chemically bonded to the surface of the $Mg(OH)_2$ particles,. After washing, the infrared spectrum of the particles was measured with an FT-IR8900 spectrometer (Shimadzu Corporation), whereupon absorption attributable to carboxylic acids was observed near 1,720 $cm^{-1}$, absorption attributable to benzene rings was observed near 700 $cm^{-1}$, and absorption attributable to carbodiimide groups was observed near 2,200 $cm^{-1}$, confirming that a carbodiimide group-containing polymer layer had formed on the $Mg(OH)_2$ particles.

Example 5

$Mg(OH)_2$ (10.0 g; Kisuma 5Q, surface-untreated $Mg(OH)_2$ produced by Kyowa Chemical Industry Co., Ltd.) having a volume mean particle diameter of 700 nm was thoroughly dispersed in 40.0 g of cyclohexanone within a 100 ml three-necked flask, following which 1.5 g of diphenylmethane-4,4-diisocyanate (abbreviated below as "MDI"; produced by Dow Chemical Japan), 0.04 g of p-cat and 0.2 g of phenyl isocyanate (produced by Tokyo Kasei Kogyo Co., Ltd.) as an end-capping agent were added, and the system was heated at 100°C for about 3 hours.
Following reaction completion, the $Mg(OH)_2$ particles were washed with THF and suction filtered four times to remove unreacted monomer and polymer which had not chemically bonded to the surface of the $Mg(OH)_2$ particles. After washing, the infrared spectrum of the particles was measured with an FT-IR8900 spectrometer (Shimadzu Corporation), whereupon absorption attributable to carbodiimide groups was observed near 2,200 $cm^{-1}$, confirming that a carbodiimide group-containing polymer layer had formed on the silica particles.

Example 6

$Al(OH)_3$ (10.0 g: C301, surface-untreated $Al(OH)_3$ produced by Sumitomo Chemical Co., Ltd.) having a volume mean particle diameter of 1.0 $\mu$m was thoroughly dispersed in 60.0 g of cyclohexanone (Wako Pure Chemical Industries) within a 100 ml round-bottomed flask. $Al(OH)_3$ particles on the surface of which a carbodiimide compound was chemically bonded were then synthesized by the same method as in Example 1.

Example 7

$Al(OH)_3$ (10.0 g; C301, surface-untreated $Al(OH)_3$ produced by Sumitomo Chemical) having a volume mean particle diameter of 1.0 $\mu$m was thoroughly dispersed in 60.0 g of cyclohexanone (Wako Pure Chemical Industries) within a 100 ml round-bottomed flask. $Al(OH)_3$ particles on the surface of which a carbodiimide compound was chemically

bonded were then synthesized by the same method as in Example 2.

Example 8

$Al(OH)_3$ (10.0 g; C301, surface-untreated $Al(OH)_3$ produced by Sumitomo Chemical) having a volume mean particle diameter of 1.0 μm was thoroughly dispersed in 60.0 g of cyclohexanone (Wako Pure Chemical Industries) within a 100 ml round-bottomed flask. $Al(OH)_3$ particles on the surface of which a carbodiimide compound was grafted to a styrene-methacrylic acid copolymer were then synthesized by the same method as in Example 3.

Example 9

$Al(OH)_3$ (10.0 g; C301, surface-untreated $Al(OH)_3$ produced by Sumitomo Chemical) having a volume mean particle diameter of 1.0 μm was thoroughly dispersed in 60.0 g of cyclohexanone (Wako Pure Chemical Industries) within a 100 ml round-bottomed flask. $Al(OH)_3$ particles having thereon a carbodiimide group-containing polymer layer were then synthesized by the same method as in Example 4.

Example 10

$Al(OH)_3$ (10.0 g; C301, surface-untreated $Al(OH)_3$ produced by Sumitomo Chemical) having a volume mean particle diameter of 1.0 μm was thoroughly dispersed in 60.0 g of cyclohexanone (Wako Pure Chemical Industries) within a 100 ml round-bottomed flask. $Al(OH)_3$ particles having thereon a carbodiimide group-containing polymer layer were then synthesized by the same method as in Example 5.

Comparative Example 1

$Al(OH)_3$ (10.0 g; C301, surface-untreated $Al(OH)_3$ produced by Sumitomo Chemical) having a volume mean particle diameter of 1.0 μm was thoroughly dispersed in 60.0 g of cyclohexanone (Wako Pure Chemical Industries) within a 100 ml round-bottomed flask. Next, 0.03 g of 3-aminopropyltriethoxysilane (a silane coupling agent produced by Chisso Corporation) was added, and the flask contents were stirred at 65°C for 30 minutes.
Following reaction completion, the $Al(OH)_3$ particles were washed with THF and suction filtered four times to remove unreacted silane coupling agent.
The thickness of the organic layer on the surface of the $Mg(OH)_2$ particles and the $Al(OH)_3$ particles obtained in Examples 1 to 10 of the invention and in Comparative Example 1, and the weight-average molecular weight (Mw) of the polymer forming the surface organic layer in the respective examples were determined in the manner described below. The thickness of the organic layer on the $Mg(OH)_2$ particles (Kisuma 5A, produced by Kyowa Chemical Industry) surface treated with an organic material that were used in the subsequently described examples was also determined. Those results are presented together in Table 1.

[Method of Measuring the Weight-Average Molecular Weight]

The weight-average molecular weight was measured by gel filtration chromatography (GPC) using the following apparatus and conditions.

Molecular Weight Measurement Conditions

| | |
|---|---|
| GPC apparatus: | C-R7A, manufactured by Shimadzu Corporation |
| Detector: | UV spectrophotometer detector (SPD-6A), manufactured by Shimadzu Corporation |
| Pump: | Molecular weight distribution measurement system pump (LC-6AD), manufactured by Shimadzu Corporation |
| Columns: | A total of three columns connected in series; two Shodex KF804L (Showa Denko K.K.) columns and one Shodex KF806 (Showa Denko) |
| Solvent: | Tetrahydrofuran |
| Measurement temperature: | 40°C |

[Method of Measuring Thickness of Polymer Layer]

The densities of the respective particles in Examples 1 to 10 and Comparative Example 1 were determined using a gas pycnometer (Accupyc 1330, manufactured by Shimadzu Corporation; in helium). Based on these results and the densities of the untreated $Mg(OH)_2$ particles (Kisuma 5Q) and untreated $Al(OH)_3$ (C301) particles, the volume of the polymer layer, the volume of the inorganic hydroxide, and the total surface area per cubic centimeter ($cm^3$) of the inorganic hydroxide having a polymer layer thereon were determined. The thickness of the polymer layer was calculated from these values. The volumes and total surface area were determined by assuming the $Mg(OH)_2$ particles and the $A1(OH)_3$ particles at this time to be truly spherical.

Table 1

| | Thickness (nm) | Average molecular weight (Mw) |
|---|---|---|
| Example 1 | 5.8 | 830 |
| Example 2 | 8.9 | 1,000 |
| Example 3 | 9.3 | 15,000 |
| Example 4 | 9.5 | 20,000 |
| Example 5 | 6.0 | 1,200 |
| Example 6 | 8.5 | 830 |
| Example 7 | 13.0 | 1,000 |
| Example 8 | 13.6 | 16,000 |
| Example 9 | 13.8 | 22,000 |
| Example 10 | 8.8 | 1,200 |
| Comparative Example 1 | 0* | -- |
| Kisuma 5A | 0* | -- |
| Note: In Table 1, "0* " signifies that, based on calculations, the thickness was substantially 0 nm. | | |

Specimens were prepared by dispersing the particles obtained in Examples 1 to 10 and Comparative Example 1, Kisuma 5A (Comparative Example 2), surface-untreated magnesium hydroxide (Comparative Example 3) and surface-untreated aluminum hydroxide (Comparative Example 4) in THF, methanol, methyl ethyl ketone (MEK, produced by Sanyo Chemical) and pH 7 water. The volume mean particle diameters and standard deviations were determined using these specimens.
Specifically, first the respective particles obtained in Examples 1 to 10 of the invention and Comparative Examples 1 to 4 were added to the solvents mentioned above in respective amounts of 10 wt%, and dispersed for 30 minutes with an ultrasonic dispersing unit (Ultra Turrax T18, manufactured by Nissei Corporation).
Next, the volume mean particle diameter was measured using a particle size analyzer (MICROTRAC HRA 9320-X100 (measurement range, 0.7 μm to 700 μm), manufactured by Nikkiso Co., Ltd.).
In addition, the values obtained when the particle diameter (M2) and standard deviation (A2) in THF and the particle diameter (M4) and standard deviation (A4) in water for Examples 1 to 5 are divided by, respectively, the particle diameter (M1) and standard deviation (A1) in THF and the particle diameter (M3) and standard deviation (A3) in water for Comparative Example 3; and the values obtained when the particle diameter (M2) and standard deviation (A2) in THF and the particle diameter (M4) and standard deviation (A4) in water for Examples 6 to 10 are divided by, respectively, the particle diameter (M1) and standard deviation (A1) in THF and the particle diameter (M3) and standard deviation (A3) in water for Comparative Example 4 are shown together in Table 2.
Also shown in Table 2 are the values obtained when the particle diameter (M2') and standard deviation (A2') in MEK and the particle diameter (M4') and standard deviation (A4') in methanol for Examples 1 to 5 are divided by, respectively, the particle diameter (M1') and standard deviation (A1') in MEK and the particle diameter (M3') and standard deviation (A3') in methanol for Comparative Example 3; and the values obtained when the particle diameter (M2') and standard deviation (A2') in MEK and the particle diameter (M4') and standard deviation (A4') in methanol for Examples 6 to 10 are divided by, respectively, the particle diameter (M1') and standard deviation (A1') in MEK and the particle diameter

(M3') and standard deviation (A3') in methanol for Comparative Example 4.
The standard deviation, which is a measure of the width in the distribution of the measured particle size, is the value calculated by the following formula.

$$\text{Standard deviation} = (d84\% - d16\%)/2$$

where

d84%: volume mean particle diameter (μm) at 84% of cumulative curve

d16%: volume mean particle diameter (μm) at 16% of cumulative curve

Table 2

| | THF | | | | Water | | | |
|---|---|---|---|---|---|---|---|---|
| | Volume mean particle diameter (μm) | Standard deviation | (M2) / (M1) | (A2) / (A1) | Volume mean particle diameter (μm) | Standard deviation | (M4) / (M3) | (A4) / (A3) |
| Example 1 | 1.22 | 0.55 | 0.31 | 0.28 | 4.74 | 1.60 | 2.30 | 1.25 |
| Example 2 | 1.05 | 0.50 | 0.26 | 0.27 | 10.03 | 4.29 | 4.87 | 3.35 |
| Example 3 | 1.25 | 0.50 | 0.32 | 0.26 | 10.01 | 4.29 | 4.86 | 3.35 |
| Example 4 | 1.02 | 0.45 | 0.26 | 0.23 | 10.05 | 4.30 | 4.88 | 3.36 |
| Example 5 | 1.20 | 0.53 | 0.30 | 0.27 | 4.05 | 1.60 | 1.97 | 1.25 |
| Example 6 | 1.30 | 0.60 | 0.17 | 0.19 | 5.06 | 4.00 | 1.80 | 2.58 |
| Example 7 | 1.32 | 0.61 | 0.18 | 0.19 | 11.0 | 4.50 | 3.91 | 2.90 |
| Example 8 | 1.35 | 0.72 | 0.18 | 0.23 | 10.08 | 4.60 | 3.59 | 2.97 |
| Example 9 | 1.25 | 0.50 | 0.17 | 0.16 | 10.10 | 4.70 | 3.59 | 3.03 |
| Example 10 | 1.35 | 0.70 | 0.18 | 0.22 | 5.03 | 3.90 | 1.79 | 2.52 |
| Comparative Example 1 | 6.50 | 2.50 | -- | -- | 4.05 | 1.87 | -- | -- |
| Comparative Example 2 | 3.05 | 1.05 | -- | -- | 3.50 | 1.55 | -- | -- |
| Comparative Example 3 | 3.95 | 1.95 | -- | -- | 2.06 | 1.28 | -- | -- |
| Comparative Example 4 | 7.43 | 3.20 | -- | -- | 2.81 | 1.55 | -- | -- |
| | MEK | | | | Methanol | | | |
| | Volume mean particle diameter (μm) | Standard deviation | (M2') / (M1') | (A2') / (A1') | Volume mean particle diameter (μm) | Standard deviation | (M4') / (M3') | (A4') / (A3') |
| Example 1 | 1.45 | 0.73 | 0.19 | 0.25 | 3.05 | 2.00 | 2.85 | 4.00 |

(continued)

| | MEK | | | | Methanol | | | |
|---|---|---|---|---|---|---|---|---|
| | Volume mean particle diameter (μm) | Standard deviation | (M2') / (M1') | (A2') / (A1') | Volume mean particle diameter (μm) | Standard deviation | (M4') / (M3') | (A4') / (A3') |
| Example 2 | 1.28 | 0.56 | 0.16 | 0.19 | 6.90 | 2.40 | 6.44 | 4.80 |
| Example 3 | 1.25 | 0.55 | 0.16 | 0.19 | 6.80 | 2.35 | 6.35 | 4.70 |
| Example 4 | 1.26 | 0.56 | 0.16 | 0.19 | 6.82 | 2.39 | 6.37 | 4.78 |
| Example 5 | 1.46 | 0.73 | 0.19 | 0.25 | 2.50 | 0.92 | 2.34 | 1.84 |
| Example 6 | 1.35 | 0.63 | 0.25 | 0.25 | 5.00 | 2.50 | 2.30 | 2.14 |
| Example 7 | 1.28 | 0.56 | 0.23 | 0.22 | 22.05 | 6.23 | 10.11 | 5.32 |
| Example 8 | 1.16 | 0.65 | 0.21 | 0.26 | 20.52 | 6.05 | 9.41 | 5.17 |
| Example 9 | 1.16 | 0.65 | 0.21 | 0.26 | 25.00 | 8.00 | 11.47 | 6.84 |
| Example 10 | 1.28 | 0.56 | 0.23 | 0.22 | 5.50 | 3.00 | 2.52 | 2.56 |
| Comparative Example 1 | 4.65 | 1.70 | -- | -- | 1.80 | 1.10 | -- | -- |
| Comparative Example 2 | 4.50 | 2.03 | -- | -- | 1.20 | 0.58 | -- | -- |
| Comparative Example 3 | 7.77 | 2.93 | -- | -- | 1.07 | 0.50 | -- | -- |
| Comparative Example 4 | 5.47 | 2.54 | -- | -- | 2.18 | 1.17 | -- | -- |

Aside from adding the particles of Examples 1 to 10 and Comparative Examples 1 to 4 to THF in an amount of 30 wt%, the same operations were carried out. The volume mean particle diameters and standard deviations were measured, in addition to which the following volume mean particle diameter ratio was determined. Those results are presented in Table 3.

Volume mean particle diameter ratio (30) =
(volume mean particle diameter when 30 wt% is added)
/(volume mean particle diameter when 10 wt% is added)

Table 3

| | THF | | |
|---|---|---|---|
| | Volume mean particle diameter (μm) | Standard deviation | Volume mean particle diameter ratio (30) |
| Example 1 | 1.23 | 0.55 | 1.01 |
| Example 2 | 1.07 | 0.52 | 1.02 |
| Example 3 | 1.26 | 0.51 | 1.01 |
| Example 4 | 1.03 | 0.45 | 1.01 |

(continued)

| | THF | | |
|---|---|---|---|
| | Volume mean particle diameter (μm) | Standard deviation | Volume mean particle diameter ratio (30) |
| Example 5 | 1.22 | 0.54 | 1.02 |
| Example 6 | 1.31 | 0.60 | 1.01 |
| Example 7 | 1.33 | 0.61 | 1.01 |
| Example 8 | 1.36 | 0.73 | 1.01 |
| Example 9 | 1.26 | 0.57 | 1.01 |
| Example 10 | 1.37 | 0.70 | 1.01 |
| Comparative Example 1 | 8.45 | 10.00 | 1.30 |
| Comparative Example 2 | 5.49 | 7.05 | 1.80 |
| Comparative Example 3 | 20.05 | 16.00 | 5.08 |
| Comparative Example 4 | 26.08 | 21.00 | 3.51 |

Aside from adding the particles of Examples 1 to 10 and Comparative Examples 1 to 4 to THF in an amount of 50 wt%, the same operations were carried out. The volume mean particle diameters and standard deviations were measured, in addition to which the following volume mean particle diameter ratio was determined. Those results are presented in Table 4.

**Volume mean particle diameter ratio (50) = (volume mean particle diameter when 50 wt% is added) /(volume mean particle diameter when 10 wt% is added)**

Table 4

| | THF | | |
|---|---|---|---|
| | Volume mean particle diameter (μm) | Standard deviation | Volume mean particle diameter ratio (50) |
| Example 1 | 1.24 | 0.56 | 1.02 |
| Example 2 | 1.08 | 0.55 | 1.03 |
| Example 3 | 1.28 | 0.53 | 1.02 |
| Example 4 | 1.04 | 0.50 | 1.02 |
| Example 5 | 1.22 | 0.55 | 1.02 |
| Example 6 | 1.33 | 0.62 | 1.02 |
| Example 7 | 1.35 | 0.65 | 1.02 |
| Example 8 | 1.38 | 0.75 | 1.02 |
| Example 9 | 1.27 | 0.53 | 1.02 |
| Example 10 | 1.39 | 0.72 | 1.03 |
| Comparative Example 1 | 20.10 | 16.00 | 3.09 |
| Comparative Example 2 | 27.50 | 21.00 | 9.02 |

(continued)

| | THF | | |
|---|---|---|---|
| | Volume mean particle diameter (μm) | Standard deviation | Volume mean particle diameter ratio (50) |
| Comparative Example 3 | not measurable | -- | -- |
| Comparative Example 4 | not measurable | -- | -- |
| Not measurable: The particles agglomerated, making measurement impossible. | | | |

Aside from adding the particles of Examples 1 to 10 and Comparative Examples 1 to 4 to THF in an amount of 60 wt%, the same operations were carried out. The volume mean particle diameters and standard deviations were measured, in addition to which the following volume mean particle diameter ratio was determined. Those results are presented in Table 5.

$$\text{Volume mean particle diameter ratio (60)} = \text{(volume mean particle diameter when 60 wt\% is added)} / \text{(volume mean particle diameter when 10 wt\% is added)}$$

Table 5

| | THF | | |
|---|---|---|---|
| | Volume mean particle diameter (μm) | Standard deviation | Volume mean particle diameter ratio (60) |
| Example 1 | 1.29 | 0.56 | 1.06 |
| Example 2 | 1.09 | 0.55 | 1.04 |
| Example 3 | 1.28 | 0.55 | 1.02 |
| Example 4 | 1.06 | 0.50 | 1.04 |
| Example 5 | 1.23 | 0.55 | 1.03 |
| Example 6 | 1.34 | 0.63 | 1.03 |
| Example 7 | 1.35 | 0.66 | 1.02 |
| Example 8 | 1.38 | 0.75 | 1.02 |
| Example 9 | 1.28 | 0.60 | 1.02 |
| Example 10 | 1.39 | 0.72 | 1.03 |
| Comparative Example 1 | 440 | 240 | 67.69 |
| Comparative Example 2 | 530 | 200 | 173.8 |
| Comparative Example 3 | not measurable | -- | -- |
| Comparative Example 4 | not measurable | -- | -- |
| Not measurable: The particles agglomerated, making measurement impossible. | | | |

As shown in Tables 3 to 5 above, when THF is used as the dispersing medium, the above-described dispersion properties, such as volume mean particle diameter and standard deviation, can be achieved with the addition of the inventive flame retardant in an amount of not only 10 wt%, but also 30 wt%, 50 wt% and even 60 wt% or more. Moreover, trends similar to those for THF were obtained using MEK and toluene (Sanyo Chemical Industries) as the dispersing medium, even when the flame retardant was added in amounts of 30 wt%, 50 wt% and 60 wt% or more.

Highly loaded dispersions can thus be obtained in which increases in viscosity and agglomeration have been suppressed and a highly dispersed state has been achieved. Hence, higher loadings in organic resins at the time of molding are possible, and further improvements can be made in processability and in the physical properties after molding. These too are major features of the present invention.

[2] Preparation of Inorganic/Organic Composite Flame-Retardant Compositions (Molded Bodies)

Examples 11 to 20, and Comparative Examples 5 to 12

In the respective examples, a dispersion prepared by dispersing 4.61 g of the $Mg(OH)_2$ particles synthesized in Example 1 (Example 11), 4.65 g of the $Mg(OH)_2$ particles synthesized in Example 2 (Example 12), 4.66 g of the $Mg(OH)_2$ particles synthesized in Example 3 (Example 13), 4.66 g of the $Mg(OH)_2$ particles synthesized in Example 4 (Example 14), 4.61 g of the $Mg(OH)_2$ particles synthesized in Example 5 (Example 15), 4.61 g of the $Al(OH)_3$ particles synthesized in Example 6 (Example 16), 4.65 g of the $Al(OH)_3$ particles synthesized in Example 7 (Example 17), 4.66 g of the $Al(OH)_3$ particles synthesized in Example 8 (Example 18), 4.66 g of the $Al(OH)_3$ particles synthesized in Example 9 (Example 19), 4.61 g of the $Al(OH)_3$ particles synthesized in Example 10 (Example 20), 4.50 g of commercial surface-treated $Mg(OH)_2$ (Kisuma 5A, produced by Kyowa Chemical Industry) (Comparative Example 5), 4.50 g of untreated $Mg(OH)_2$ (Kisuma 5Q, produced by Kyowa Chemical Industry) (Comparative Example 6), 4.50 g of the $Al(OH)_3$ surface treated in Comparative Example 1 (Comparative Example 9) or 4.50 g of untreated $Al(OH)_3$ (C301, produced by Sumitomo Chemical) (Comparative Example 10) in 4 g of THF was added to a mixture composed of 3.60 g of epoxy resin (Epiclon N-740, produced by Dainippon Ink & Chemicals, Inc.) and 0.90 g of a curing agent (Novacure HX3722, produced by Asahi Kasei Corporation), thereby giving an inorganic/organic composite flame-retardant composition.
Additional compositions were similarly prepared by adding 0.11 g of carbodiimide compound synthesized from TDI (which is the same amount as the carbodiimide group-containing organic layer on the surface of the $Mg(OH)_2$ particles in Example 1) to, respectively, 4.50 g of untreated $Mg(OH)_2$ (Kisuma 5Q) (Comparative Example 7) and 4.50 g of surface-treated $Mg(OH)_2$ (Kisuma 5A) (Comparative Example 8); and by adding 0.11 g of polyTDI (which is the same amount as the polymer layer in Example 6) to, respectively, 4.50 g of untreated $Al(OH)_3$ (C301) (Comparative Example 11) and 4.50 g of the $Al(OH)_3$ synthesized in Comparative Example 1 (Comparative Example 12).
Here, the amounts of $Mg(OH)_2$ or $Al(OH)_3$ added in the respective examples of the invention and comparative examples were set, based on the method of calculation described below, so that the amounts of virgin $Mg(OH)_2$ or $Al(OH)_3$ included in each composition are the same.

Method of Calculation

The densities of 5 g of, respectively, the $Mg(OH)_2$ synthesized in Example 1, Kisuma 5A and Kisuma 5Q were measured with a gas pycnometer (Accupyc 1330, manufactured by Shimadzu Corporation; in helium). The results were 2.39 g/cm$^3$ for both Kisuma 5A and Kisuma 5Q, and 2.33 g/cm$^3$ for the $Mg(OH)_2$ synthesized in Example 2.
Here, because the carbodiimide group-containing organic compound with which surface treatment was carried out in Example 1 has a density of 1.22 g/cm$^3$ and untreated $Mg(OH)_2$ (Kisuma 5Q) has a density of 2.39 g/cm$^3$, letting the volume of the compound obtained in Synthesis Example 1 per cubic centimeter of the treated $Mg(OH)_2$ be X cm$^3$, we get the following:

$$1.22X + 2.39(1-X) = 2.33.$$

Thus, X is 0.048 cm$^3$.
Therefore, the weight of the compound obtained in Synthesis Example 1 which serves as the surface layer per cubic centimeter of the treated $Mg(OH)_2$ is 0.048 cm$^3$ x 1.22 g/cm$^3$ = 0.059 g, and the weight of Kisuma 5Q is (1 - 0.048) cm$^3$ x 2.39 g/cm$^3$ = 2.28 g.
Hence, the amount of the compound obtained in Synthesis Example 1 which has bonded to the above synthesized $Mg(OH)_2$ as a proportion of the total is given by (100 x 0.059 g)/(2.28 + 0.048 g) = 2.5 wt%.
From the above, the amounts of $Mg(OH)_2$ present in 4.50 g of Kisuma 5A, in 4.50 g of Kisuma 5Q, and in 4.61 g of the $Mg(OH)_2$ synthesized in Example 1 are equivalent.
The amounts of polymer on the $Mg(OH)_2$ particles and the $Al(OH)_3$ particles obtained in Examples 2 to 10 were also calculated in the same way. The respective amounts of polymer were found to be 3.3 wt% in Example 2, 3.5 wt% in Example 3, 3.5 wt% in Example 4, 2.5 wt% in Example 5, 2.5 wt% in Example 6, 3.3 wt% in Example 7, 3.5 wt% in Example 8, 3.5 wt% in Example 9, and 2.5 wt% in Example 10.

The compositions prepared in above Examples 11 to 20 and Comparative Examples 5 to 12 were formed into films by bar coating. The resulting films were dried overnight, then cured by 1 hour of heat treatment at 100°C followed by 0.5 hour of heat treatment at 150°C. The cured films obtained from each of these compositions were formed to two thicknesses of about 150 μm and about 600 μm. The properties described below were evaluated for each of the cured films thus obtained. The results are shown in Tables 6 to 9.

[Formability and Physical Properties of Compositions (Shaped Articles)]

(1) Formability Test

Aside from the dimensions of test specimens thereof, the above cured films were evaluated based on the following criteria in accordance with the method described in JIS K 7104.

Good: The inorganic hydroxide particles were very uniformly loaded, and the cured film had a smooth surface (as determined by touch and sight).
Fair: The inorganic hydroxide particles were uniformly loaded, but the surface of the cured film was uneven in places.
NG: The inorganic hydroxide particles were not uniformly loaded, and the entire surface of the cured film was uneven.

(2) Mechanical Strength Test

The elastic modulus of the cured film (150 μm) was measured at room temperature using a thermal diffraction/rheology system (EXTAR 600; Seiko Instrument).

Good: The elastic modulus improved substantially over that in Comparative Example 5 (Examples 11 to 15, Comparative Examples 6 to 8). The elastic modulus improved substantially over that in Comparative Example 9 (Examples 16 to 20, Comparative Examples 10 to 12).
Fair: The elastic modulus was the same or improved slightly over that in Comparative Example 5 (Comparative Examples 11 to 15, Comparative Examples 6 to 8). The elastic modulus was the same or improved slightly over that in Comparative Example 9 (Comparative Examples 16 to 20, Comparative Examples 10 to 12).
NG: The elastic modulus decreased.

(3) Dielectric Constant Test

The dielectric constant of the cured film (150 μm) was measured at room temperature and a frequency of 1 GHz using a dielectric constant measuring instrument (4291B Impedance Material Analyzer, manufactured by Agilent Technologies). The compositions containing untreated $Mg(OH)_2$ or $A1(OH)_3$ had a poor formability and a variable dielectric constant. Hence, the average of the values measured at four places was used as the dielectric constant.

Good: The dielectric constant was significantly lower than in Comparative Example 5 (Examples 11 to 15, Comparative Examples 6 to 8). The dielectric constant was significant lower than in Comparative Example 9 (Examples 16 to 20, Comparative Examples 10 to 12).
Fair: The dielectric constant was slightly lower than in Comparative Example 5 (Examples 11 to 15, Comparative Examples 6 to 8). The dielectric constant was slightly lower than in Comparative Example 9 (Examples 16 to 20, Comparative Examples 10 to 12).
NG: The dielectric constant did not decrease.

(4) Bending Test

The cured film (600 μm) was cut to a width of 100 mm and a length of 4 cm, and the maximum point flexural stress was measured with a three-point bending tester (Microforce Tester, manufactured by Instron Corporation). The measurement conditions were a support span of 10 mm, an initial load of 5 g, and a bending speed of 10 mm/min.

Good: The flexural stress was significantly higher than in Comparative Example 5 (Examples 11 to 15, Comparative Examples 6 to 8). The flexural stress was significant higher than in Comparative Example 9 (Examples 16 to 20, Comparative Examples 10 to 12).
Fair: The flexural stress was slightly higher than in Comparative Example 5 (Examples 8 to 12, Comparative Examples 8 to 10).
The flexural stress was slightly higher than in Comparative Example 9 (Examples 13 and 14, Comparative

Example 12).

NG: The flexural stress either did not increase, or it decreased.

Table 6

| | Formability | Elastic modulus | | | Dielectric constant | | | Three-point bending test | | |
|---|---|---|---|---|---|---|---|---|---|---|
| | | Measured value ($10^9$ Pa) | Elastic modulus ratio | Rating | Measured value | Dielectric constant ratio | Rating | Measured value | Stress ratio | Rating |
| Example 11 | good | 2.5 | 1.47 | good | 4.46 | 0.991 | good | 970 | 1.49 | good |
| Example 12 | good | 2.4 | 1.41 | good | 4.45 | 0.989 | good | 850 | 1.31 | good |
| Example 13 | good | 2.0 | 1.18 | good | 4.45 | 0.989 | good | 790 | 1.22 | good |
| Example 14 | good | 2.0 | 1.18 | good | 4.46 | 0.991 | good | 750 | 1.15 | good |
| Example 15 | good | 2.5 | 1.47 | good | 4.45 | 0.990 | good | 980 | 1.51 | good |
| Example 16 | good | 1.9 | 1.58 | good | 3.75 | 0.987 | good | 900 | 1.55 | good |
| Example 17 | good | 1.9 | 1.58 | good | 3.75 | 0.987 | good | 830 | 1.43 | good |
| Example 18 | good | 1.8 | 1.50 | good | 3.76 | 0.989 | good | 750 | 1.29 | good |
| Example 19 | good | 1.8 | 1.50 | good | 3.76 | 0.989 | good | 750 | 1.29 | good |
| Example 20 | good | 1.8 | 1.50 | good | 3.76 | 0.989 | good | 950 | 1.63 | good |
| Comparative Example 5 | fair | 1.7 | -- | fair | 4.53 | -- | NG | 650 | -- | -- |
| Comparative Example 6 | NG | 1.6 | 0.94 | NG | 4.53 | 1.00 | NG | 600 | 0.92 | NG |
| Comparative Example 7 | NG | 1.8 | 1.05 | fair | 4.53 | 1.00 | NG | 600 | 0.92 | NG |
| Comparative Example 8 | fair | 1.7 | 1.00 | fair | 4.53 | 1.00 | NG | 655 | 1.01 | fair |
| Comparative Example 9 | fair | 1.2 | -- | fair | 3.80 | -- | NG | 580 | -- | -- |
| Comparative Example 10 | NG | 1.1 | 0.92 | NG | 3.80 | 1.00 | NG | 505 | 0.87 | NG |
| Comparative Example 11 | NG | 1.3 | 1.00 | fair | 3.80 | 1.00 | NG | 505 | 0.87 | NG |

(continued)

| | Formability | Elastic modulus | | | Dielectric constant | | | Three-point bending test | | |
|---|---|---|---|---|---|---|---|---|---|---|
| | | Measured value ($10^9$ Pa) | Elastic modulus ratio | Rating | Measured value | Dielectric constant ratio | Rating | Measured value | Stress ratio | Rating |
| Comparative Example 12 | fair | 1.2 | 1.00 | fair | 3.80 | 1.00 | NG | 583 | 1.01 | fair |

The ratios of the various physical property ratio values shown in Table 6 were calculated relative to the data from Comparative Example 5 (commercial surface-treated $Mg(OH)_2$: Kisuma 5A) in the case of $Mg(OH)_2$; that is, with the Comparative Example 5 data serving as the denominator. In the case of $A1(OH)_3$, the ratios were similarly calculated relative to the data from Comparative Example 9 (the $A1(OH)_3$ prepared in Comparative Example 1); that is, with the Comparative Example 9 data serving as the denominator.

(5) Acid Resistance (for Cured Films (150 μm) in Examples 11 to 15 and Comparative Examples 5 to 8)

A cured film was immersed for 5 minutes or one hour in an aqueous solution containing 20 wt% of hydrochloric acid (Wako Pure Chemical Industries), after which it was rinsed with distilled water then dried, and the weights following immersion for the respective lengths of time were measured.
The acid resistance was evaluated by calculating the percent weight loss from the weight of the film prior to acid treatment and the film weight after acid treatment, and was based also on the change in color of the cured film following acid treatment.

Good: The film was acid-resistant
NG: The film lacked acid resistance

Table 7

| | Acid resistance | | | | | | |
|---|---|---|---|---|---|---|---|
| | 5 minutes | | | 1 hour | | | Rating |
| | Weight loss (%) | Color change | Weight loss ratio | Weight loss (%) | Color change | Weight loss ratio | |
| Example 11 | 4 | substantially unchanged | 0.21 | 13 | slight whitening | 0.29 | good |
| Example 12 | 4 | substantially unchanged | 0.21 | 14 | slight whitening | 0.32 | good |
| Example 13 | 5 | substantially unchanged | 0.26 | 15 | slight whitening | 0.34 | good |
| Example 14 | 5 | substantially unchanged | 0.26 | 15 | slight whitening | 0.34 | good |
| Example 15 | 5 | substantially unchanged | 0.26 | 15 | slight whitening | 0.34 | good |
| Comparative Example 5 | 19 | slight whitening | -- | 44 | white color change | -- | NG |
| Comparative Example 6 | 20 | slight whitening | 1.05 | 48 | white color change | 1.09 | NG |
| Comparative Example 7 | 20 | slight whitening | 1.05 | 48 | white color change | 1.09 | NG |
| Comparative Example 8 | 19 | slight whitening | 1.00 | 44 | white color change | 1.00 | NG |

(6) Alkali Resistance (for Cured Films (150 μm) in Examples 16 to 20 and Comparative Examples 9 to 12)

A cured film was immersed for one hour in an aqueous solution containing 50 wt% of potassium hydroxide (available from Sigma-Aldrich Japan KK), after which it was rinsed with distilled water then dried, and the weight following immersion for the above length of time was measured.
The alkali resistance was evaluated by calculating the percent weight loss from the weight of the film prior to alkali treatment and the weight after alkali treatment, and was based also on the change in color of the cured film following acid treatment.

Good: The film was alkali-resistant
NG: The film lacked alkali resistance

Table 8

| | Alkali resistance | | | |
|---|---|---|---|---|
| | 1 hour | | | Rating |
| | Weight loss (%) | Color change | Weight loss ratio | |
| Example 16 | 1 | slight whitening | 0.06 | good |
| Example 17 | 1 | slight whitening | 0.06 | good |
| Example 18 | 3 | slight whitening | 0.18 | good |
| Example 19 | 3 | slight whitening | 0.18 | good |
| Example 20 | 1 | slight whitening | 0.06 | good |
| Comparative Example 9 | 16 | white color change | -- | NG |
| Comparative Example 10 | 18 | white color change | 1.13 | NG |
| Comparative Example 11 | 18 | white color change | 1.13 | NG |
| Comparative Example 12 | 16 | white color change | 1.00 | NG |

(7) Insulation Resistance Test

To determine the insulation reliability of the above-described cured films (150 μm), the insulation resistance (MΩ) values under normal conditions (96 hours of treatment in constant-temperature, constant-humidity air at 20°C and 65% RH) and following boiling water treatment (2 hours of immersion in constant-temperature, boiling water at 100°C) were measured using an insulation resistivity tester (HP 4339B High Resistance Meter, manufactured by Hewlett Packard Japan KK).

Measurement conditions: voltage, 100 V (AC voltage); current, 500 μA
Good: Insulation resistance value decreased less than 5%
Fair: Insulation resistance value decreased 5% or more but less than 10%
NG: Insulation resistance value decreased 10% or more

(8) Water Absorption Test

The above-described cured films (thickness, 600 μm) were cut to a width of 50 mm and a length of 100 mm, and the resulting test piece was left for 24 hours in a high-temperature chamber held at 50°C. The test piece was then cooled to 20°C in a desiccator and weighed. The test piece was subsequently immersed for 24 hours in a vessel containing 23°C distilled water, following which it was removed from the vessel, the moisture was wiped off with a dry cloth, and the weight of the test piece after water absorption was measured within a period of one minute.

Good: Percent weight gain was less than in Comparative Example 5 (Examples 11 to 15, Comparative Examples 6 to 8) Percent weight gain was less than in Comparative Example 9 (Examples 16 to 20, Comparative Examples 10 to 12)
NG: Percent weight gain was the same as or more than in Comparative Example 5 (Examples 11 to 15, Comparative Examples 6 to 8) Percent weight gain was the same as or more than in Comparative Example 9 (Examples 16 to 20, Comparative Examples 10 to 12)

Table 9

| | Insulation reliability | Water absorption | |
|---|---|---|---|
| | | Weight gain (%) | Rating |
| Example 11 | good | 0.25 | good |
| Example 12 | good | 0.10 | good |
| Example 13 | good | 0.20 | good |
| Example 14 | good | 0.20 | good |
| Example 15 | good | 0.30 | good |
| Example 16 | good | 0.30 | good |
| Example 17 | good | 0.15 | good |
| Example 18 | good | 0.25 | good |
| Example 19 | good | 0.25 | good |
| Example 20 | good | 0.35 | good |
| Comparative Example 5 | fair | 0.76 | -- |
| Comparative Example 6 | NG | 0.80 | NG |
| Comparative Example 7 | NG | 0.80 | NG |
| Comparative Example 8 | fair | 0.76 | NG |
| Comparative Example 9 | fair | 0.80 | -- |
| Comparative Example 10 | NG | 0.85 | NG |
| Comparative Example 11 | NG | 0.85 | NG |
| Comparative Example 12 | fair | 0.80 | NG |

(9) Heat Resistance Test

Heat resistance tests were conducted on the above-described cured films (150 μm). The percent weight loss when a cured film was held at 200°C for 30 minutes was measured using a TG/DTA Autosampler AST-2 (manufactured by Seiko Instrument). No weight loss occurred in any of the specimens. Therefore, a decrease in heat resistance due to the surface treatment agent was not observed.

[3] Flame Retardance Test

Examples 21 to 30, and Comparative Examples 13 to 20

Aside from using the $Mg(OH)_2$ particles prepared in Example 1 (Example 21), the $Mg(OH)_2$ particles prepared in Example 2 (Example 22), the $Mg(OH)_2$ particles prepared in Example 3 (Example 23), the $Mg(OH)_2$ particles prepared in Example 4 (Example 24), the $Mg(OH)_2$ particles prepared in Example 5 (Example 25), untreated $Mg(OH)_2$ particles (Kisuma 5) (Comparative Example 13) and commercial, surface-treated $Mg(OH)_2$ (Kisuma 5A, Kyowa Chemical Industry) (Comparative Example 14) in amounts which included in each case, based on calculations, 8.3 g of $Mg(OH)_2$, inorganic/organic composite flame-retarded compositions were prepared in the same way as in Example 11. In addition, compositions were prepared in the same way as in Example 11 by adding 0.21 g of carbodiimide compound synthesized from TDI (which is the same amount as the carbodiimide group-containing organic layer on the surface of the $Mg(OH)_2$ particles of Example 1) to, respectively, untreated $Mg(OH)_2$ particles (Kisuma 5Q) (Comparative Example 15) and surface-treated $Mg(OH)_2$ (Kisuma 5A) (Comparative Example 16).

Also, aside from using the $A1(OH)_3$ particles prepared in Example 6 (Example 26), the $Al(OH)_3$ particles prepared in Example 7 (Example 27), the $Al(OH)_3$ particles prepared in Example 8 (Example 28), the $A1(OH)_3$ particles prepared in Example 9 (Example 29), the $A1(OH)_3$ particles prepared in Example 10 (Example 30), untreated $A1(OH)_3$ particles (C301) (Comparative Example 17) and the $Al(OH)_3$ particles synthesized in Comparative Example 1 (Comparative Example 18) in amounts which included in each case, based on calculations, 8.3 g of $Al(OH)_3$, inorganic/organic

composite flame-retarded compositions were prepared in the same way as in Example 11. In addition, compositions were prepared in the same way as in Example 11 by adding 0.21 g of polyTDI (which is the same amount as the polymer layer of Example 6) to, respectively, untreated $Al(OH)_3$ particles (C301) (Comparative Example 19) and the $A1(OH)_3$ particles prepared in Comparative Example 1 (Comparative Example 20).
Cured films having a thickness of about 150 μm were fabricated from each of the resulting inorganic/organic composite flame-retardant compositions in the same way as described above. A flame retardance test was carried out by the method described below, and the flame retardance in each case was determined. The results are shown in Table 10.

[Flame Retardance Test and Evaluation]

Aside from the thickness of the test specimen, flammability tests were carried out in accordance with the UL-94 vertical flame retardance test method (flammability specifications for plastic materials). The results were rated as follows in accordance with the criteria for flammability ratings of 94-V0 94-V1 and 94-V2.

Excellent: 94-V0 equivalent
Good: 94-V1 equivalent
Fair: 94-V2 equivalent

Table 10

| | Flammability test | |
|---|---|---|
| | Criteria | Rating |
| Example 21 | 94-V0 | excellent |
| Example 22 | 94-V0 | excellent |
| Example 23 | 94-V0 | excellent |
| Example 24 | 94-V0 | excellent |
| Example 25 | 94-V0 | excellent |
| Example 26 | 94-V0 | excellent |
| Example 27 | 94-V0 | excellent |
| Example 28 | 94-V0 | excellent |
| Example 29 | 94-V0 | excellent |
| Example 30 | 94-V0 | excellent |
| Comparative Example 13 | flammable | fair |
| Comparative Example 14 | flammable | good |
| Comparative Example 15 | flammable | fair |
| Comparative Example 16 | flammable | good |
| Comparative Example 17 | flammable | fair |
| Comparative Example 18 | flammable | good |
| Comparative Example 19 | flammable | fair |
| Comparative Example 20 | flammable | good |

As shown in Tables 6 to 10, the inorganic/organic composite fire-retardant compositions in the respective examples of the invention, which include the $Mg(OH)_2$ or $A1(OH)_3$ particles having a carbodiimide group-containing organic layer that were obtained in above Examples 1 to 10 of the invention, all had an excellent formability and excellent physical properties. In Examples 21 to 30 of the invention, due to the loading of the $Mg(OH)_2$ and $A1(OH)_3$ particles in a highly dispersed state within the cured films, very high flame-retarding effects were achieved.
By contrast, it is apparent from the results obtained in each of the comparative examples that, in compositions containing

$Mg(OH)_2$ or $Al(OH)_3$ particles which include like amounts of carbodiimide group-containing organic compounds, based on the inorganic hydroxide, but in which such organic compounds are not chemically bonded to the surface of the inorganic material, an improvement in the formability and physical properties was not achieved.

The above results demonstrate that inorganic hydroxides which have thereon a carbodiimide group-containing organic layer exhibit a high dispersibility and moreover are able, when mixed with a resin, to suppress the decline in physical properties that has hitherto been a problem in conventional flame-retardant compositions. Accordingly, it is possible to achieve a satisfactory flame retardance enhancing effect while preventing a decline in the physical properties. Owing to their high flame retardance, it is expected that the inorganic/organic composite flame-retardant compositions of the invention will see use in a variety of applications.

## Claims

1. A flame retardant which is **characterized by** comprising an inorganic hydroxide and a carbodiimide group-containing organic layer that is chemically bonded to a surface of the inorganic hydroxide.

2. The flame retardant of claim 1 wherein, when tetrahydrofuran is used as a dispersing medium, the inorganic hydroxide having said carbodiimide group-containing organic layer has a particle size distribution with a standard deviation ($A_2$) which satisfies the following relationship with respect to a standard deviation ($A_1$) of the particle size distribution for a surface-untreated inorganic hydroxide:

$$(A_2)/(A_1) \leq 1.0.$$

3. The flame retardant of claim 1 wherein, when tetrahydrofuran is used as a dispersing medium, the inorganic hydroxide having said carbodiimide group-containing organic layer has a volume mean particle diameter ($M_2$) which satisfies the following relationship with respect to a volume mean particle diameter ($M_1$) of a surface-untreated inorganic hydroxide:

$$(M_2)/(M_1) \leq 1.0.$$

4. The flame retardant of claim 1 wherein, when pH 7 water is used as a dispersing medium, the inorganic hydroxide having said carbodiimide group-containing organic layer has a particle size distribution with a standard deviation ($A_4$) which satisfies the following relationship with respect to a standard deviation ($A_3$) of the particle size distribution for a surface-untreated inorganic hydroxide:

$$(A_4)/(A_3) > 1.0.$$

5. The flame retardant of claim 1 wherein, when pH 7 water is used as a dispersing medium, the inorganic hydroxide having said carbodiimide group-containing organic layer has a volume mean particle diameter ($M_4$) which satisfies the following relationship with respect to a volume mean particle diameter ($M_3$) of a surface-untreated inorganic hydroxide:

$$(M_4)/(M_3) > 1.0.$$

6. The flame retardant of claim 1, wherein said carbodiimide group-containing organic layer is at least one compound selected from among carbodiimide group-containing compounds of formula (1) below and carbodiimide group-containing compounds of formula (2) below:

$$(X^1)_m\text{-Z-}[\text{A-}(R^1\text{-N=C=N})_n\text{-}R^1\text{-NCO}]_1 \qquad (1)$$

$$(X^1)_m\text{-}Z\text{-}[A\text{-}(R^1\text{-}N{=}C{=}N)_n\text{-}R^1\text{-}A\text{-}Z\text{-}(X^2)_3]_1 \qquad (2)$$

wherein

$R^1$ is a residue from an isocyanate compound;
$X^1$ and $X^2$ are each independently a hydrogen atom, a halogen atom, an alkyl group of 1 to 20 carbons which may include an unsaturated structure, an aryl group of 6 to 20 carbons, an aralkyl group of 7 to 20 carbons or an alkoxy group of 1 to 20 carbons, and $X^1$ and $X^2$ in each instance, if plural, may be the same or different;
each Z is independently a silicon atom or a titanium atom;
A is an organic group which has a valence of 2 or more and includes a bond derived from an isocyanate group;
the letters m and 1 are integers from 1 to 3 which satisfy the condition m+1 = 4; and
the letter n is an integer from 1 to 100.

**7.** The flame retardant of claim 6, wherein at least one terminal isocyanate group on the carbodiimide group-containing compound of formula (1) is capped with a functional group which is reactive with isocyanate groups.

**8.** The flame retardant of claim 7, wherein said functional group which is reactive with isocyanate groups is a hydroxyl group, a primary or secondary amino group, a carboxyl group or a thiol group.

**9.** The flame retardant of any of claims 1 to 8, wherein the carbodiimide group-containing organic layer is lipophilic.

**10.** The flame retardant of any one of claims 1 to 9, wherein the inorganic hydroxide is composed of particles having a volume mean particle diameter of from 1 nm to 100 μm.

**11.** An inorganic/organic composite flame-retardant composition which is **characterized by** comprising the flame retardant of any one of claims 1 to 10 and an organic resin.

**12.** The inorganic/organic composite flame-retardant composition of claim 11, wherein the flame retardant is included in an amount of at least 15 wt%, based on the organic resin.

**13.** The inorganic/organic composite flame-retardant composition of claim 11 or 12, wherein the flame retardant included in 1 g of the composition has a total surface area of at least 2,000 $cm^2$.

## INTERNATIONAL SEARCH REPORT

International application No.
PCT/JP2006/312398

A. CLASSIFICATION OF SUBJECT MATTER
*C08K9/04*(2006.01), *C08L101/00*(2006.01)

According to International Patent Classification (IPC) or to both national classification and IPC

B. FIELDS SEARCHED

Minimum documentation searched (classification system followed by classification symbols)
C08L3/00-13/08, C08L23/00-101/16

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,A | JP 2005-281644 A (Catalysts & Chemicals Industries Co., Ltd.), 13 October, 2005 (13.10.05), Claims (Family: none) | 1-13 |
| A | JP 9-290482 A (Tsutsunaka Plastic Industry Co., Ltd.), 11 November, 1997 (11.11.97), Full text (Family: none) | 1-13 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>05 July, 2006 (05.07.06) | Date of mailing of the international search report<br>18 July, 2006 (18.07.06) |
| Name and mailing address of the ISA/<br>Japanese Patent Office<br>Facsimile No. | Authorized officer<br><br>Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 61275359 A
- JP 63258958 A
- JP 5230279 A
- JP 51061599 A
- JP 2292316 A


### Non-patent literature cited in the description


- **L. M. ALBERINO et al.** *J. Appl. Polym. Sci.,* 1990, vol. 21, 190